# FASCICULE DE BREVET EUROPEEN

(11) **EP 2 577 729 B1**
(45) Date de publication et mention de la délivrance du brevet: **12.03.2014**
(21) Numéro de dépôt: 11723935.0
(22) Date de dépôt: 31.05.2011
(51) Int. Cl.: H01L 25/07, H01L 23/473, H01L 33/64

(54) **PUCE ELECTRONIQUE AVEC CANAUX APTES A RECEVOIR L'ECOULEMENT D'UN FLUIDE CALOPORTEUR, COMPOSANTS ELECTRONIQUES ET BRAS DE COMMUTATION INCORPORANT CETTE PUCE**
ELEKTRONISCHER CHIP MIT KANÄLEN FÜR DEN DURCHFLUSS EINES KÜHLMITTELS, ELEKTRONISCHE KOMPONENTEN UND KOMMUTIERUNGSVORRICHTUNG MIT DIESEM CHIP
ELECTRONIC CHIP HAVING CHANNELS THROUGH WHICH A COOLANT CAN FLOW, ELECTRONIC COMPONENTS AND COMMUTATION DEVICE INCORPORATING SAID CHIP

(30) Priorité: 02.06.2010 FR 1054315
(43) Date de publication de la demande: 10.04.2013
(73) Titulaire: Commissariat à l'Énergie Atomique et aux Énergies Alternatives, 75015 Paris (FR); Centre National de la Recherche Scientifique, 75016 Paris (FR); Institut Polytechnique de Grenoble, 38000 Grenoble (FR)
(72) Inventeur: AVENAS, Yvan, F-38320 Poisat (FR); CREBIER, Jean-Christophe, F-38690 Bevenais (FR); WIDIEZ, Julie, F-38000 Grenoble (FR); CLAVELIER, Laurent, F-38120 Saint-Egreve (FR); VLADIMIROVA, Kremena, F-38000 Grenoble (FR)
(74) Mandataire: Colombo, Michel
(86) Numéro de dépôt international: PCT/EP2011/058994
(87) Numéro de publication internationale: WO 2011/151351

(56) Documents cités:
- EP-A1- 1 988 572
- US-A1- 2007 117 306
- US-A1- 2007 126 103
- US-A1- 2009 294 954

## Description

L'invention concerne une puce électronique ainsi qu'un composant électronique à structure 3D incorporant cette puce électronique. L'invention concerne également un autre composant électronique ainsi qu'un bras de commutation incorporant cette puce électronique.

Un composant électronique est un composant se présentant sous la forme d'un boîtier sur la face extérieure duquel des broches de raccordement à un circuit électrique extérieur sont prévues. Un tel boîtier comprend une ou plusieurs puces électroniques et des connexions électriques pour raccorder ce ou ces puces électroniques aux broches de raccordement. La ou les puces électroniques ainsi que les connexions électriques sont enrobées dans un même matériau d'enrobage destiné à les protéger de l'environnement extérieur. Typiquement, le matériau d'enrobage est un polymère électriquement isolant. Souvent, ce matériau d'enrobage forme en même temps les parois extérieures du boîtier.

Chaque puce électronique est un morceau d'un substrat semiconducteur plus connu sous le terme anglais de « wafer ». Ces puces électroniques sont fabriquées par des procédés collectifs de fabrication de la microélectronique. Ces procédés consistent notamment à déposer et à graver les unes sur les autres des couches successives pour fonctionnaliser le substrat semiconducteur, c'est-à-dire obtenir le fonctionnement souhaité de la puce électronique.

Un grand nombre de ces puces remplissent la fonction d'interrupteur commandable. En effet, c'est l'une des fonctions de base de l'électronique. Ces puces électroniques commutent entre un état passant et un état non passant en réponse à un signal de commande. Pour cela, les puces électroniques comportent généralement un substrat semi-conducteur s'étendant essentiellement dans un plan et présentant une zone active formée d'au moins une région dopée de type P et d'au moins une région dopée de type N qui forment une ou plusieurs jonctions P-N par l'intermédiaire desquelles passe l'essentiel du courant utile lorsque cette puce électronique est dans un état passant. La zone active est également connu sous le terme anglais de « drift region ».

Dans l'état passant, la zone active oppose une faible résistance au passage du courant utile qui circule entre au moins deux broches de raccordement de la puce électronique. A l'inverse, dans l'état non passant ou bloqué, la zone active oppose une résistance beaucoup plus forte au passage du courant utile entre ces mêmes broches de raccordement. Typiquement, le rapport U/J est supérieur à 10⁶Ω/cm² et, de préférence supérieur à 10⁸Ω/cm² dans l'état non passant, où U est la tension entre les broches de raccordement et J est la densité du courant traversant la zone active. Idéalement, le passage du courant utile est totalement interrompu dans l'état non passant. Dans l'état passant, ce même rapport U/J est inférieur à 1Ω/cm² et, de préférence à 0,01Ω /cm².

La commutation entre l'état passant et l'état non passant peut être commandée par un signal de commande injecté sur une électrode de commande dédiée à cette fonction. Cette électrode de commande est par exemple connue sous le terme de « grille » lorsque la puce électronique est un transistor à effet de champ comme un IGBT (Insulated Gate Bipolar Transistor) ou un transistor MOS (Metal-Oxide Semiconductor), ou sous le terme de « base » dans le cas d'un transistor bipolaire ou encore sous le terme de « gachette » dans le cas d'un thyristor. La commutation entre ces deux états peut également uniquement dépendre de la tension appliquée entre les broches de raccordement comme dans le cas d'une diode. Dans ce dernier cas, le signal de commande qui fait commuter la diode entre les deux états passant et non passant est la tension appliquée entre sa cathode et son anode.

Des pertes par effet joule se produisent dans les puces électroniques et viennent diminuer leur performance ou contenir leurs plages d'utilisation en courant par exemple. Ces pertes sont d'autant plus importantes que simultanément la tension entre les broches de raccordement et l'intensité du courant sont importantes. Si aucune précaution n'est prise, les pertes par effet joule peuvent conduire à la destruction du composant électronique à cause de sa limitation en température. Ainsi, il est quasiment indispensable de refroidir les composants électroniques de puissance, c'est-à-dire des composants aptes à être traversés par un courant utile dont la densité est supérieure à 1A/cm2, et de préférence supérieure à 100A/cm2, pendant, par exemple, dix minutes ou même des heures sans être détruit. Les puces électroniques et les composants sont donc fréquemment associées à un circuit de refroidissement.

Il a déjà été proposé de creuser, au moins en partie, des microcanaux dans l'une des faces du substrat de la puce électronique dans une région non fonctionnalisée de cette puce. Les microcanaux sont des canaux dont la plus grande largeur transversale est inférieure à 500 µm et, de préférence, inférieure à 100 µm. Par exemple, de tels microcanaux sont décrits dans l'article suivant :
Tuckerman D.B., Pease R.F.W., « High Performance Heat Sinking For VLSI », IEEE Electron Devices Letters, volume EDL-2-5, pages 126-129, 1981.

Dans la majorité des cas, ces microcanaux s'étendent parallèlement au plan du substrat de la puce pour ne pas interférer avec les zones où passe du courant. Toutefois, récemment, dans le domaine des circuits intégrés, il a été proposé que ces microcanaux traversent le substrat perpendiculairement au plan de celui-ci (voir par exemple la demande de brevet US2009/0294954). Dans ce dernier cas, les microcanaux sont disposés de manière à soigneusement éviter la ou les zones actives du circuit intégré où circule du courant utile. En effet, les zones actives d'un circuit intégré sont extrêmement petites (de l'ordre de quelques nanomètres à quelques dizaines de nanometres carrés). Ainsi, si un microcanal devait traverser ou toucher cette zone active, il la ferait disparaitre. Cette dernière technique impose donc de prévoir, dès la conception du circuit intégré, des emplacements non fonctionnels du point de vue électronique qui peuvent être traversés par des microcanaux. Ces emplacements non fonctionnels augmentent la surface de la puce et ne facilitent pas la miniaturisation des puces.

Aujourd'hui, pour améliorer les puces électroniques, un refroidissement encore plus efficace des puces électroniques est nécessaire. Par ailleurs, les microcanaux parallèle au substrat sont longs, ce qui entraîne des pertes de charge importantes et diminue le coefficient d'échange thermique entre le fluide caloporteur et le substrat.

En plus ou en alternative de l'utilisation de microcanaux, les pistes électriques qui amènent et collectent le courant utile qui traverse la zone active sont également utilisées pour drainer de la chaleur en dehors de la zone active et donc pour la refroidir.

A cause de cette double fonction des pistes électriques, les contacts entre ces pistes électriques et la zone active doivent non seulement assurer une bonne conductivité électrique mais également une bonne conduction de la chaleur. Pour assurer une bonne conduction de la chaleur, ces contacts électriques sont réalisés par soudure ou par collage ou par très fortes pressions. De plus, leurs surfaces sont généralement importantes pour réduire la résistance au passage de la chaleur. Or de tels contacts bons conducteurs thermiques et électriques assurent généralement également la tenue mécanique de la puce et ils subissent un stress mécanique lors des variations de température. En effet, le substrat et les pistes électriques n'ont généralement pas les mêmes coefficients de dilatation thermique et il n'existe aucun degré de liberté entre eux.

De l'état de la technique est également connu des demandes de brevet EP1988572A1, US2007/117306A1 et US2007/126103A1.

L'invention vise à remédier à au moins l'un de ces inconvénients. Elle a donc pour objet une puce électronique conforme à la revendication 1.

Dans la puce électronique ci-dessus, le ou les canaux traversent la zone active c'est-à-dire la zone où se produit l'essentiel des pertes par effet Joule. L'efficacité des échanges thermiques entre cette puce électronique et les canaux s'en trouve améliorée car ceux-ci sont alors beaucoup plus proches des sources de pertes par effet Joule. Ainsi, le refroidissement de la puce est amélioré.

Les modes de réalisation de cette puce électronique peuvent comporter une ou plusieurs des caractéristiques des revendications dépendantes.

Ces modes de réalisation présentent en outre les avantages suivantes :
- des canaux traversant le substrat perpendiculairement à son plan sont plus courts ce qui réduit les pertes de charge et augmente le coefficient d'échange thermique,
- l'utilisation de plus d'une centaine de canaux en parallèle par rapport au passage du fluide permet de réduire fortement les pertes de charge tout en offrant une surface d'échange thermique accrue et permet de rendre négligeable les conséquences de l'obstruction d'un seul de ces canaux par une saleté;
- maintenir le cumul des surfaces des sections transversales des canaux, inférieur au tiers de la surface de la zone active permet de conserver ou d'améliorer les caractéristiques électriques de la puce électronique sans augmenter, voire en diminuant, la surface totale de sa zone active;
- utiliser des canaux dont au moins une portion s'évase dans la région la moins dopée permet de limiter la concentration des lignes d'équipotentiel du champ électrique à l'intérieur du fluide caloporteur et diminue le champ électrique à l'interface entre la puce et le matériau isolant ce qui permet de maintenir la tension de claquage et de relâcher les contraintes sur le choix du fluide caloporteur;
- recouvrir les flancs du canal d'un matériau diélectrique au niveau où le canal traverse l'interface entre les régions dopées de types différents permet de maintenir la tension de claquage de la puce électronique puisque le rapprochement des lignes d'équipotentiel du champ électrique se produit alors surtout à l'intérieur de ce matériau diélectrique et non plus dans le fluide caloporteur ;
- utiliser des couches de métallisation dont l'épaisseur e est telle que le ratio ρ/e est inférieur à 0,1 mΩ permet d'obtenir une répartition plus uniforme du courant dans la zone active ce qui permet de maintenir la tension de claquage de la puce électronique, d'étendre l'aire de sécurité du composant électronique incorporant cette puce et de rigidifier le matériau semi-conducteur;
- passer les canaux entre les grilles permet de ne pas modifier le routage des pistes conductrices qui relient ces grilles.

L'invention a également pour objet un composant électronique conforme à la revendication 11.

Le raccordement électrique de la puce uniquement sur la périphérie de sa zone active permet de découpler les chemins de propagation électrique et thermique ce qui autorise l'optimisation des prises de contact électrique.

Les modes de réalisation de ce composant peuvent comporter les caractéristiques de la revendication 12.

Les modes de réalisation de ce composant électronique présentent en outre les avantages suivants :
- utiliser un contact pressé entre la piste électrique et la couche de métallisation permet à cette piste électrique de glisser sur la couche de métallisation en réponse à une variation de température sans que cela endommage la puce électronique ;
- la broche de raccordement en forme de tube creux remplit simultanément deux fonctions à savoir le raccordement électrique et le raccordement fluidique de la puce électronique ce qui simplifie la réalisation du composant électronique.

L'invention a également pour objet un composant électronique ayant une structure 3D conforme à la revendication 13.

Le composant électronique à structure 3D ci-dessus utilise avantageusement les canaux pour dissiper efficacement la chaleur au sein même de l'empilement des puces électroniques. Ceci améliore le refroidissement des puces électroniques empilées et permet de réaliser, par exemple, une nouvelle architecture de composants électroniques de puissance.

Les modes de réalisation de ce composant électronique à structure 3D peuvent comporter les caracteristiques de la revendication 14.

Les modes de réalisation de ces composants électroniques à structure 3D présente en outre les avantages suivants :
- la présence d'un collecteur de fluide de refroidissement logé entre les première et seconde puces électroniques permet d'améliorer le refroidissement du composant électronique et d'uniformiser la pression entre les différents canaux qui traversent une même puce électronique.

Enfin, l'invention a pour objet un bras de commutation conforme à la revendication 15.

Refroidir le condensateur à l'aide de canaux connectés fluidiquement aux canaux utilisés pour refroidir les interrupteurs commandables permet de placer ce condensateur à proximité de ces interrupteurs commandables sans que celui-ci ne s'échauffe trop à cause de cette proximité. L'amplitude des surtensions générées par l'inductance des lignes de raccordement électrique de ce bras de commutation est diminuée du fait de cette proximité.

L'invention sera mieux comprise à la lecture de la description qui va suivre, donnée uniquement à titre d'exemple non limitatif et faite en se référant aux dessins sur lesquels :
- la figure 1 est une illustration schématique et partielle d'un composant électronique équipé d'une puce électronique,
- la figure 2 est une illustration en vue de dessus de la face supérieure de la puce électronique,
- la figure 3 est une illustration schématique de la répartition transversale de la température à l'intérieur d'un canal,
- la figure 4 est un graphe illustrant l'évolution du coefficient d'échange thermique moyen entre un fluide caloporteur s'écoulant à l'intérieur d'un canal et la longueur de ce canal ;
- la figure 5 est un organigramme d'un premier procédé de fabrication de la puce électronique du composant électronique de la figure 1,
- les figures 6 à 11 sont des illustrations schématiques et en coupe de différentes étapes du procédé de la figure 5,
- la figure 12 est un organigramme d'un deuxième procédé de fabrication de la puce électronique de la figure 1,
- les figures 13 à 15 sont des illustrations schématiques et en coupe de différentes étapes du procédé de la figure 12,
- la figure 16 est un organigramme d'un troisième procédé de fabrication de la puce électronique de la figure 1,
- les figures 17, 19 et 20 sont des illustrations schématiques et en coupe de différentes étapes du procédé de fabrication de la figure 16,
- la figure 18 est une illustration schématique en vue de dessus d'une couche de métallisation perméable utilisée dans procédé de la figure 16,
- la figure 21 est une illustration schématique et partielle d'une puce électronique utilisée pour réaliser un transistor MOSFET (Metal Oxyde Semiconductor Field Effect Transistor),
- la figure 22 est une illustration schématique et partielle en vue de dessus de cellules élémentaires du transistor MOSFET de la figure 21 ;
- la figure 23 est une illustration schématique et partielle en vue de dessus du positionnement de pistes conductrices vis-à-vis de la zone active de la puce électronique de la figure 21 ;
- la figure 24 est une illustration schématique et en coupe d'un autre mode de réalisation de la puce de la figure 21 ;
- la figure 25 est une illustration partielle et en vue de dessus de différentes répartitions possibles de canaux dans les puces des figures 21 et 24 ;
- les figures 26 et 27 représentent schématiquement et en coupe verticale deux modes de réalisation différents d'un composant électronique à structure 3D utilisant les puces électroniques des figures 21 ou 24 ;
- la figure 28 est une illustration schématique d'un composant électronique incorporant une ou plusieurs puces électroniques telles que celle de la figure 1 ;
- la figure 29 est une illustration schématique d'un bras de commutation intégré; et
- la figure 30 est une illustration schématique d'une lampe LED (Light Emitting Diode) en boîtier.

Dans ces figures, les mêmes références sont utilisées pour désigner les mêmes éléments.

Dans la suite de cette description, les caractéristiques et fonctions bien connues de l'homme du métier ne sont pas décrites en détail.

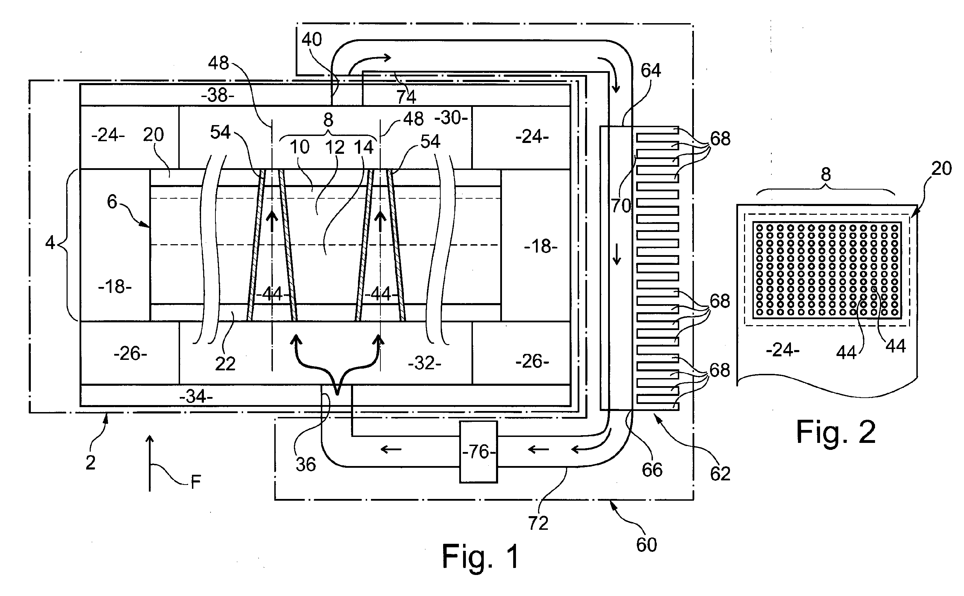

Dans la suite de cette description, les termes « vertical » et « horizontal » sont définis par rapport à la direction verticale F représentée sur la figure 1. De façon similaire, les termes « inférieur » et « supérieur » se réfèrent aux parties d'un élément situées vers le bas, respectivement vers le haut, dans la direction F.

La figure 1 représente un composant électronique 2 comportant une puce électronique 4 enrobée dans une couche d'enrobage, non représentée, en matériau électriquement isolant. La couche d'enrobage est par exemple en polymère isolant ou un gel diélectrique. Cette puce 4 est électriquement raccordée à des broches de raccordement du composant 2 par des pistes électriques 24, 26. Ces pistes électriques sont également enrobées dans le même matériau d'enrobage.

Plus précisément, la suite de cette description est faite dans le cas particulier où la puce 4 est une puce électronique de puissance, c'est-à-dire capable d'être traversée par un courant utile dont la densité est supérieure à 1A/cm² est, typiquement, supérieure à 50 ou 100A/cm².

Pour simplifier la description, la puce 4 est décrite ici dans le cas particulier ou celle-ci est une diode de puissance. Plus précisément, la puce 4 est ici une diode PIN (c'est-à-dire une diode possédant, entre deux régions fortement dopées P+ et N+ une région quasi intrinsèque de faible dopage).

Ici, cette diode de puissance est capable de supporter, lorsqu'elle est polarisée en inverse, une tension d'au moins 50 volts et, de préférence, d'au moins 600 volts.

Une telle diode est non conductrice jusqu'à une tension de seuil, dite d'avalanche, quand elle est polarisée en inverse. Dans l'état non conducteur, elle est uniquement traversée par des courants de fuite très inférieurs au courant utile qui traverse cette même diode lorsque celle-ci est dans l'état passant. Cette diode est dans l'état passant quand elle est polarisée en direct.

La puce 4 comprend un substrat semi-conducteur 6. Ce substrat est un morceau d'une galette ou « Wafer » en anglais. Par exemple, le substrat 6 est un substrat semi-conducteur en silicium ou en nitrure de gallium (GaN) ou en carbure de silicium (SiC). Dans la suite de cette description, on suppose que le substrat 6 est en silicium. Le substrat 6 s'étend essentiellement dans un plan perpendiculaire à la direction F. L'épaisseur de ce substrat dans la direction F est sensiblement homogène. Typiquement, elle est comprise entre 1 µm et 800 µm et, de préférence, comprise entre 5 et 200 µm. Ici l'épaisseur du substrat 6 est de 110 µm. Ce substrat 6 présente une face plane supérieure à une face plane inférieure.

Sur la figure 1, les traits ondulés verticaux qui coupent le substrat 6 indiquent qu'une grande portion du substrat 6 n'a pas été représentée sur la figure 1 pour la simplifier.

Le substrat 6 comporte une zone active 8. La zone active 8 est la zone qui commute entre l'état passant et l'état non passant. Elle est traversée par la majorité du courant utile dans l'état passant. Elle tient la tension dans l'état non passant. Cette zone 8 correspond à la zone dans laquelle se produit l'essentiel des pertes par effet Joule du composant 2.

Dans le cas particulier d'un composant électronique de puissance, la surface de la zone active perpendiculaire à la direction F est grande, c'est-à-dire supérieure à 10 µm² et, de préférence, supérieure à 100 ou 500 µm² voire même supérieure à 1 ou 2 mm².

Pour commuter entre l'état passant et l'état non passant, la zone active est ici formée d'un empilement d'une ou plusieurs régions dopées de types différents pour former une ou plusieurs jonctions P-N. Grâce à ces régions dopées, la zone active 8 présente des propriétés dissymétriques de transfert de courant.

Ici, la zone active 8 comprend une région 10 fortement dopée de type P située au-dessus d'une région 12 faiblement dopée de type N, elle-même située au-dessus d'une région 14 fortement dopée de type N. Classiquement, le dopage des régions 10, 12 et 14 est noté, respectivement, P+, N- et N+. Ces régions de dopages différents sont situées l'une au-dessus de l'autre dans la direction F. Sur la figure 1, ces régions sont séparées par des lignes en pointillée. La jonction P-N est formée par les régions 10 et 12. La région 14 sert essentiellement à rendre conductrice la face inférieure du substrat 6.

A titre d'exemple, la concentration en dopants de type P de cette région 10 est égale à 3 x 10¹⁷/cm³. La concentration en dopants de type N de la région 12 est, par exemple, égale à 2 x 10¹⁴ /cm³. La concentration en dopants de type N de la région 14 est au moins 1000 ou 10000 fois supérieure à la concentration de la région 12. Par exemple, la concentration en dopant de type N de la région 14 est égale à 5 x 10¹⁹/cm³.

Ici, les régions 10, 12 et 14 s'étendent sur toute la largeur du substrat 6 jusqu'à la terminaison périphérique de la jonction P-N.

La région 10 forme la face supérieure du substrat 6. Son épaisseur dans la direction F est par exemple inférieure à 3 µm.

Par exemple, la région 12 présente une épaisseur dans la direction F comprise entre 3 et 250 µm.

L'épaisseur de la région 14 est, par exemple, comprise entre 5 et 525 µm dans la direction F.

_La zone active 8 est entourée par une zone périphérique 18. La zone 18 est ici conçue de manière à maintenir maximale la tension de claquage de la puce 4 et proche de celle d'une jonction plane. La tension de claquage est la tension au-delà de laquelle la puce devient conductrice alors même qu'elle est commandée pour rester dans l'état non passant. Dans le cas des diodes, la tension de claquage correspond à la tension inverse maximale qui peut être appliquée à la diode sans provoquer une augmentation exponentielle du courant dans la diode induit par une accélération excessive des porteurs libres transitant dans la zone de charge d'espace. La zone 18 n'est pas traversée par le courant utile. Typiquement, seuls des courants de fuite peuvent traverser la zone périphérique 18. L'intensité de ces courants de fuite est au moins dix fois inférieure à l'intensité du courant utile.

La terminaison périphérique de la zone active est adaptée pour favoriser les prises de contact électrique en périphérie du composant.

Ici, la zone périphérique est réalisée en matériau diélectrique. De plus, l'interface entre la zone active 8 et la zone périphérique 18 est réalisée de manière à limiter la concentration des lignes d'équipotentiel du champ électrique dans cette zone 18. Ceci permet de limiter les effets de bord. Différentes solutions peuvent être mises en oeuvre telles que les solutions décrites dans les sections 3.2 et 3.3 du document suivant :
Philippe Leturck, « *Tenue en tension des semi-conducteurs de puissance* », Techniques de l'ingénieur, Traité Génie électrique, B 3 104.

Les faces supérieure et inférieure de la zone active 8 sont recouvertes de couches de métallisation, respectivement, 20 et 22. Ces couches de métallisation sont réalisées dans un matériau électriquement conducteur c'est-à-dire dont la conductivité électrique est supérieure à 10⁵ ou 10⁶ S.m⁻¹. De préférence, le matériau utilisé pour réaliser ces couches 20, 22 est choisi pour avoir un coefficient de dilatation thermique égal à celui du substrat 6 à ± 100% près sans que cela soit restrictif. Par exemple, les couches 20 et 22 sont réalisées en molybdène ou en tungstène si le substrat 6 est réalisé en silicium ou encore en alliage CuMo, CuW, CuC, AIC. Elles peuvent aussi être réalisées en cuivre.

Ces couches 20 et 22 recouvrent la totalité des faces supérieure et inférieure de la zone active 8 de manière à répartir uniformément le courant utile dans toute la section transversale de la zone active. De préférence, ces couches 20 et 22 ne s'étendent pas au-delà de la périphérie de la zone active 8. Leur épaisseur e respective est ici choisie de manière à ce qu'elle respecte le critère suivant : ρ/e < 0,1 mΩ, où p est la conductivité électrique du matériau utilisé pour réaliser la couche 20 ou 22.

De préférence, l'épaisseur e des couches 20, 22 est également choisie pour rigidifier le substrat 6 et pour augmenter la capacité calorifique de la puce 4 et donc ralentir ses variations de température. Enfin, ces couches 20 et 22 peuvent aussi être utilisées pour adapter le coefficient de dilatation thermique du substrat 6 à celui de pistes conductrices 24, 26 formées sur les couches de métallisation.

Par exemple, ici, l'épaisseur des couches 20 et 22 est supérieure à 5 µm et de préférence supérieure à 10 ou 100 µm.

La couche 20 correspond à l'anode de la diode tandis que la couche 22 correspond à sa cathode.

Le composant 2 comprend également les pistes conductrices 24 et 26 en contact mécanique et électrique, respectivement, avec les couches 20 et 22. Ces pistes 24 et 26 permettent, respectivement, de raccorder l'anode et la cathode de la diode aux broches de raccordement à un circuit électrique extérieur au composant 2. Ces pistes 24 et 26 sont réalisées dans un matériau électriquement conducteur tel que, par exemple, du cuivre.

Les pistes 24 et 26 sont uniquement en contact mécanique et électrique avec la périphérie extérieure des couches 20 et 22 pour laisser libre l'aire des faces supérieure et inférieure, respectivement, des couches 20 et 22 à l'aplomb de la zone active 8.

Ici, le contact entre les pistes 24, 26 et les couches 20, 22 est conçu pour assurer une bonne conduction électrique mais pas nécessairement une bonne conduction thermique. Il assure également la tenue mécanique de la puce. Par exemple, le contact entre les pistes 24, 26 et les couches 20, 22 est un contact faiblement pressé c'est-à-dire un contact électrique assuré uniquement par l'appui de cette piste sur la face de la couche de métallisation correspondante avec, par exemple, une pression inférieure à 10 MPa. Les contacts pressés ne font intervenir ni soudure ni collage. De plus, ils permettent à la piste de glisser sur la face de la couche de métallisation avec laquelle elle est en contact en réponse à une variation de température. Ce type de contact limite donc les stress mécaniques provoqués par une variation de température. La robustesse de la puce 4 s'en trouve accrue.

Le composant 2 comprend des collecteurs 30, 32 conformés pour qu'un fluide caloporteur lèche les faces supérieure et inférieure, respectivement, des couches 20 et 22, pour les refroidir.

Le collecteur 32 est une cavité dont la paroi supérieure est définie par la face inférieure de la couche 22. Les parois latérales de ce collecteur 32 sont définies par les faces verticales de la piste 26. Enfin, la paroi inférieure de ce collecteur 32 est définie par la face supérieure d'une couche 34 en matériau diélectrique. Cette couche 34 comprend une bouche d'admission 36 de fluide caloporteur à l'intérieur du collecteur 32.

De façon similaire, le collecteur 30 correspond à une cavité dont la paroi inférieure est définie par la paroi supérieure de la couche 20. La paroi latérale de cette cavité est définie par la face verticale de la piste 24 et la paroi supérieure est définie par une couche 38 en matériau diélectrique. Une bouche d'échappement 40 de fluide caloporteur est creusée dans la couche 38.

Ici, pour refroidir la puce 4 au plus près de la zone dans laquelle apparaissent les pertes par effet Joule, celle-ci comporte des microcanaux 44 traversant la zone active 8. Pour simplifier la figure 1, seuls deux microcanaux 44 sont représentés.

Ces microcanaux traversent les régions dopées 10, 12 et 14 et traversent donc la jonction P-N formée dans la zone active 8.

Pour augmenter la densité de microcanaux par unité de surface de la zone active, le nombre de microcanaux est supérieur à 50, 100, 500 ou 1000 microcanaux par mm². En effet, plus la densité des microcanaux augmente plus l'efficacité du refroidissement est importante et plus les pertes de charge diminuent. De plus, un nombre important de microcanaux augmente la robustesse de la puce 4 vis-à-vis de l'obstruction d'un de ces microcanaux par une poussière ou une saleté. En effet, la perte d'un ou plusieurs microcanaux sur plus d'un millier a des conséquences négligeables sur le fonctionnement du circuit de refroidissement de la puce 4 et l'isotherme à sa surface.

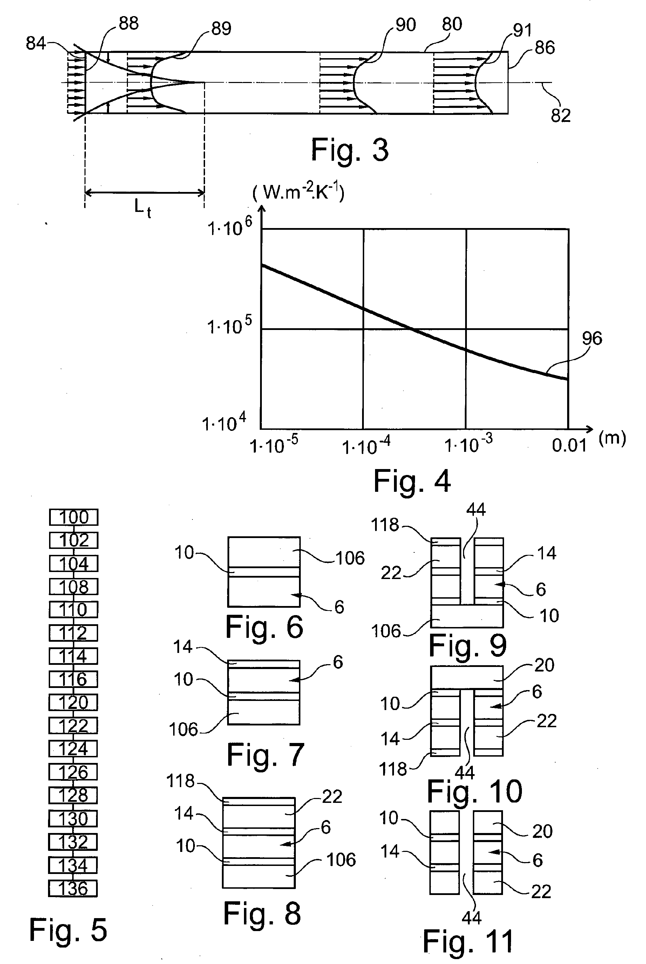

De préférence, les microcanaux sont rectilignes et traversent de part en part le substrat 6 dans une direction sensiblement parallèle à la direction F. Par sensiblement parallèle, on désigne une direction colinéaire avec la direction F à ± 45° près. Un tel choix de la direction des microcanaux permet de décroître les pertes de charge car leur longueur est diminuée par rapport aux microcanaux de l'état de la technique qui s'étendent parallèlement au plan du substrat. De plus, cela augmente le coefficient d'échange thermique car leur longueur est suffisamment courte pour que l'écoulement du fluide caloporteur soit en régime non établi sur une grande partie du canal. Le régime non établi est défini plus en détail en regard de la figure 3.

Dans le cas particulier décrit ici, chaque microcanal 44 admet un axe ou un plan de symétrie 48. Cet axe ou ce plan de symétrie est parallèle à la direction F.

De préférence, le diamètre hydraulique D de ces microcanaux 44 est strictement inférieur à 2Dₜ et, de préférence, à Dₜ. Le diamètre Dₜ est défini par la relation suivante en régime laminaire : Dₜ = L/(0,05 Re_{D} x Pr), où
- Re_{D} est le nombre de Reynolds de l'écoulement du fluide caloporteur,
- L est la longueur du microcanal,
- Dₜ est le diamètre hydraulique moyen du microcanal sur toute sa longueur, et
- Pr est le nombre de Prandtl.

Lorsque le microcanal 44, n'a pas une section transversale constante sur tout sa longueur, le diamètre D est la moyenne des diamètres hydrauliques du microcanal sur toute sa longueur L.

La longueur L est imposée par l'épaisseur de la puce 4 qui est elle-même imposée par des considérations électriques telles que la tenu en tension souhaitée pour la puce 4.

Pour la détermination du nombre de Reynolds Re_{D}, le fluide caloporteur et le débit de ce fluide dans le microcanal pris en compte sont ceux rencontrés lors d'une utilisation normale du composant 2. Par exemple le débit est compris entre 1 ml/minute et 10 l/minute et, de préférence, entre 10 ml/minute et 2 litre/min pour, par exemple, une puissance dissipée de 100W. Des exemples de fluides caloporteurs sont donnés plus loin.

De préférence, le cumul des surfaces des sections transversales des microcanaux est inférieur au tiers de la surface de la zone active et, de préférence, inférieure à 25% ou 10 % de la surface de la zone active. Par surface de la section transversale, on désigne ici la surface moyenne des sections transversales d'un microcanal 44 le long de toute sa longueur à travers le substrat 6.

Une telle limite de la surface occupée par les microcanaux permet au moins de compenser la diminution des performances de la puce 4 liée au fait que sa zone active 8 est amputée de la surface nécessaire au passage des microcanaux 44. En effet, toute diminution de la surface de la zone active se traduit, par exemple, par une augmentation de la densité de courant ce qui peut se traduire par une augmentation des densités de pertes au sein de la puce 4. Par contre, l'augmentation de la densité de puissance à évacuer est ici compensée par un meilleur refroidissement qui permet, au contraire, d'augmenter la puissance maximale admissible par la puce 4. Ainsi, en limitant le cumul des surfaces des sections transversales des microcanaux au tiers de la surface de la zone active, il est possible de conserver les caractéristiques électriques de la puce électronique, et généralement de les améliorer, sans pour autant augmenter la surface de la zone active, voire même en la diminuant, par rapport au cas où il n'y aurait pas de microcanaux traversant cette zone active.

Ici, les microcanaux 44 sont répartis dans la zone active pour maintenir sensiblement constante la température de la zone active sur toute sa largeur et ainsi avoir des isothermes parallèles à sa face supérieure. La température est sensiblement constante si l'écart entre le point le plus chaud et le point le plus froid est inférieur à 1 °C. A cet effet, par exemple, les microcanaux 44 sont uniformément répartis sur toute la surface de la zone active.

De préférence, la section transversale de chaque microcanal est rectangulaire.

Ici, le plus petit diamètre hydraulique de chaque microcanal est inférieur à 500 µm et, de préférence, compris entre 1 µm et 500 µm. De façon encore plus avantageuse, ce plus petit diamètre hydraulique est compris entre 10 et 100 µm ou entre 50 et 100 µm.

Ici, les microcanaux traversent également les couches 20 et 22 de métallisation. Les couches 20 et 22 sont ainsi rendues perméables aux fluides caloporteurs. De plus, cela étend la longueur des microcanaux et participent à l'évacuation de la chaleur par augmentation de la surface d'échange thermique.

De préférence, la section transversale de chaque microcanal s'évase au niveau où se développe le champ électrique dans la zone de tenue en tension, c'est-à-dire ici la région 12, en allant de la région de la jonction P-N la plus dopée (ici la région 10) vers la région la moins dopée (ici la région 12). Cet évasement de la section transversale de chaque microcanal permet de limiter la concentration des lignes d'équipotentiel du champ électrique à l'intérieur du fluide caloporteur. On maintient, voire on améliore, ainsi la tension de claquage de la puce 4. En effet, la tension de claquage d'un volume important de fluide caloporteur est généralement au moins dix fois inférieure à la tension de claquage de la zone active 8. Cet évasement permet d'éloigner les unes des autres les lignes d'équipotentiel du champ électrique à l'intérieur du fluide caloporteur. Cet effet, associé à de petites dimensions pour lesquelles la tenue diélectrique des fluides augmente fortement, réduit ainsi le risque de dépassement de la tension de claquage du fluide caloporteur. En faisant cela, on améliore les performances de la puce 4 et on réduit les contraintes sur le choix du fluide caloporteur.

Ici, la section transversale de chaque microcanal s'évase continûment au fur et à mesure que l'on s'enfonce dans le substrat 6 dans la direction opposée à la direction F. La pente de cet évasement est supérieure à 10 % et, de préférence, supérieure à 25, 50 ou 100 %. La pente en pourcentage est définie par la relation suivante : x% = Max(r)/2L, où :
- Max(r) est la largeur maximale du microcanal à l'intérieur du substrat 6, et
- L est la longueur du microcanal à travers le substrat 6.

Dans ce mode particulier de réalisation, toujours pour améliorer ou maintenir les performances électriques et notamment la tension de claquage de la puce 4, une couche 54 de passivation en matériau diélectrique recouvre le flancs intérieurs des microcanaux au moins au niveau où le microcanal traverse l'interface entre deux régions dopées de types différents. En effet, les lignes d'équipotentiel du champ électrique ont tendance à se concentrer à l'intérieur du fluide caloporteur notamment au niveau des interfaces entre deux régions dopées de types différents. Ainsi, en appliquant la couche 54 de passivation à cet emplacement, les lignes d'équipotentiel du champ électrique sont concentrées non plus à l'intérieur du fluide caloporteur mais à l'intérieur du matériau diélectrique formant la couche 54. Or cette couche 54 présente une tension de claquage au moins dix fois supérieure à celle du fluide caloporteur. On améliore donc ainsi la tension de claquage de la puce 4.

La tension de claquage du fluide caloporteur peut être mesurée selon les normes américaines ASTM D1816 ou D3300 ou la norme européenne CEI60156 et selon la norme américaine ASTM D149 pour les solides.

Par exemple, la couche 54 est réalisée en SiO₂ si le substrat est en silicium et en Si₃N₄ si le substrat est en nitrure de gallium.

Dans le cas particulier représenté, la couche 54 s'étend uniformément sur toute la longueur de chaque microcanal à travers le substrat 6 et les couches 20 et 22.

La puce 4 présente de nombreux avantages et en particulier celui de dissocier les flux électriques du principal flux thermique. Ici, le principal flux thermique permettant de refroidir la zone active 8 est vertical et passe au milieu de la zone active. A l'inverse, les flux électriques sont uniquement situés sur la périphérie de la zone active 8. On comprend donc que lorsque l'on réalise un contact électrique, il n'est plus nécessaire de se soucier de réaliser en plus un bon contact thermique puisque le flux thermique est essentiellement évacué par l'intermédiaire des microcanaux et non pas par l'intermédiaire des pistes conductrices 24 et 26.

Le composant 2 est associé à un circuit 60 de refroidissement. Ce circuit 60 comprend un échangeur thermique 62 permettant de refroidir le fluide caloporteur. Cet échangeur 62 comprend une bouche d'entrée 64 et une bouche 66 de sortie du fluide caloporteur.

Par exemple, l'échangeur 62 est un radiateur à ailettes qui évacue les calories prélevées dans le fluide caloporteur vers l'air ambiant. Ici, cet échangeur comprend des ailettes 68 qui s'étendent à partir d'une base 70 transpercée par un ou plusieurs canaux dans lesquels s'écoulent le fluide caloporteur entre les bouches 64 et 66. Ici, ce radiateur est réalisé dans un matériau ayant une très bonne conductivité thermique c'est-à-dire une conductivité thermique supérieure à 10 Wm⁻¹. K⁻¹ et de préférence supérieure à 100 Wm⁻¹.K⁻¹. Par exemple, cet échangeur est réalisé en aluminium ou en cuivre.

Le circuit 60 comprend également des conduits 72 et 74, respectivement d'amenée et de collecte, du fluide caloporteur. Le conduit 72 est raccordé entre les bouches 66 et 36 tandis que le conduit 74 est raccordé entre les bouches 40 et 64.

Le circuit 60 comprend aussi une pompe 76 qui fait circuler le fluide caloporteur de l'échangeur 62 jusqu'aux microcanaux 44 et des microcanaux 44 jusqu'à la bouche 64.

Enfin, un vase d'expansion est prévu dans le circuit 60. Ce vase d'expansion est par exemple une poche d'air.

Sur la figure 1, des flèches représentent le sens de circulation du fluide caloporteur à l'intérieur du circuit 60 et des microcanaux 44 et 46.

Le fluide caloporteur est ici un fluide caloporteur diélectrique c'est-à-dire dont la conductivité électrique est inférieure à 0,1 S.m⁻¹ et de préférence inférieure à 10⁻⁵ ou 10⁻⁶ S.m⁻¹. Sa permittivité relative ε^{r} est strictement supérieure à 1 et, également de préférence, inférieure à 10 ou 20. Plus la permittivité relative du fluide caloporteur est faible, plus le champ électrique maximal observé dans le fluide caloporteur diminue:

Le fluide caloporteur est par exemple de l'eau déionisée ou de l'huile. Par exemple, l'huile est celle connue sous le nom commercial « Coolanol »® de la société Exxon Mobil®.

Le fluide caloporteur est également choisi pour sa compatibilité chimique avec les matériaux du composant 2 avec lesquels il est directement en contact et, en particulier, ceux de la puce 4. Par exemple, le fluide caloporteur doit être le plus inerte possible.

Lors du fonctionnement du circuit 60, la pompe est actionnée pour faire circuler le fluide caloporteur de l'échangeur 62 jusqu'au collecteur 32. A partir du collecteur 32, le fluide caloporteur traverse la zone active 8 par l'intermédiaire des microcanaux et débouche dans le collecteur 30. Le conduit 74 rapatrie le fluide caloporteur réchauffé du collecteur 30 jusqu'à l'échangeur 62 pour que celui-ci soit de nouveau refroidi.

La figure 2 présente la face supérieure de la piste 24. Sur cette figure 2, une ligne en pointillée représente le contour de la couche 20. Les cercles sur la face supérieure de la couche 20 représentent les orifices débouchant des microcanaux 44.

Comme illustré, la piste 24 est en contact mécanique et électrique avec la couche de métallisation 20 sur la majorité de sa périphérie extérieure sans venir obstruer les microcanaux 44. Dans le cas particulier représenté, la piste 24 est en contact mécanique et électrique directement avec la totalité de la périphérie extérieure de la couche 20. La piste 26 est agencée de façon identique vis-à-vis de la couche 22.

La figure 3 représente un canal 80 qui s'étend le long d'un axe de symétrie 82 horizontal. Ce canal 80 possède une extrémité 84 par l'intermédiaire de laquelle rentre un fluide et une extrémité 86 de sortie de ce fluide. Les courbes 88 à 91 représentent le profil de la température à l'intérieur d'une section transversale du fluide qui s'écoule dans le canal 80. Initialement, au niveau de l'extrémité d'entrée, la température du fluide est homogène dans toute la section transversale. La courbe 88 est donc rectiligne et les flèches illustrant la valeur de la température en fonction de leur proximité de la paroi interne du canal 80 ont toutes la même amplitude. Au fur et à mesure que le fluide progresse à l'intérieur du canal 80, le fluide en contact avec la paroi interne du canal 80 s'échauffe plus rapidement que le fluide situé sur l'axe 82. C'est ce que représente la courbe 89. Après une longueur Lₜ mesurée depuis l'extrémité 84, le profil de température atteint un régime stable et ne se modifie plus. C'est ce que représente les courbes 90 et 91. Seule l'amplitude des flèches augmente au fur et à mesure que l'on se rapproche de l'extrémité 86.

La longueur que doit parcourir une tranche transversale de fluide depuis l'extrémité 84 avant d'arriver à un profil stable de température est notée Lₜ. Le régime d'écoulement est dit « thermiquement non établi » sur toute la longueur Lₜ. A l'inverse, le régime d'écoulement est dit « thermiquement établi » au-delà de la longueur Lₜ.

Lorsque le régime d'écoulement est thermiquement non établi, la différence de température entre la paroi du canal 80 et le fluide caloporteur en contact avec cette paroi est plus importante que lorsque le régime est établi. Dès lors, le coefficient d'échange thermique est meilleur. On comprend donc que choisir le diamètre hydraulique D du microcanal pour que sa longueur L soit inférieure à 2Lₜ et, de préférence, à Lₜ permet d'améliorer le coefficient d'échange thermique entre le fluide caloporteur et le substrat 6. La longueur Lₜ est donnée par la formule Lₜ = 0,05 Re_{D} x D x Pr précédemment introduite pour un écoulement laminaire.

Le graphe de la figure 4 montre (courbe 96) l'évolution du coefficient d'échange thermique d'un microcanal en fonction de sa longueur. Sur ce graphe, les axes des abscisses et des ordonnées représentent, respectivement, la longueur L du canal et le coefficient d'échange thermique. On voit que la réduction de la longueur des microcanaux augmente très sensiblement le coefficient d'échange thermique moyen et donc l'efficacité du refroidissement.

La figure 5 représente un premier procédé de fabrication de la puce 4 dans le cas particulier où celle-ci est une diode de puissance.

Initialement, lors d'une étape 100, le substrat 6 est fourni. Par exemple, ce substrat est épais, c'est-à-dire que son épaisseur est supérieure à 200 µm. Ici son épaisseur est inférieure à 750 µm. Ce substrat est uniformément légèrement dopé pour former la région 12. Pour simplifier les figures 6 à 11, la région 12 n'est pas représentée.

Ensuite, lors d'une étape 102, la région dopée 10 est réalisée sur une face de ce substrat.

Lors d'une étape 104, une poignée 106 (figure 6) est collée sur la face supérieure de la région 10 opposée au substrat 6. Dans cet exemple la poignée est une plaque de silicium oxydée ou une plaque de silicium comportant un oxyde déposé en surface. L'oxyde permet le collage de cette poignée sur le substrat de silicium. Ce collage est suffisamment résistant pour la mise en oeuvre des étapes suivantes tout en restant facilement décollable le moment venu.

Lors d'une étape 108, l'ensemble représenté sur la figure 6 est retourné à l'aide de la poignée 106.

Eventuellement, lors d'une étape 110, le substrat 6 est alors aminci. Par exemple, son épaisseur peut être réduite à moins de 200 µm ou 110 µm.

Ensuite, lors d'une étape 112 (figure 7), la face du substrat 6 opposée à la poignée 106 est dopée pour former la région 14.

Lors d'une étape 114, la couche 22 de métallisation est reportée sur la face de la région 14 opposée à la poignée 106. Par exemple la couche 22 est une plaque métallique (Cu, Mo, W, MoCu, ... etc) d'épaisseur supérieure à 200µm ou une plaque de silicium sur laquelle on a préalablement déposé une couche métallique dont l'épaisseur est contrôlée. Dans ce dernier cas, l'épaisseur de la couche métallique peut être très fine (c'est-à-dire inférieure à 200 µm) et de l'ordre de quelques dizaines de micromètres. L'épaisseur de la plaque de silicium est quant à elle supérieure à 200µm. Par exemple, la couche de métallisation est collée à l'aide de procédés tels que le collage direct, eutectique ou par thermo compression. La couche 22 peut également être électrodéposée directement sur la région 14. Dans ce cas son épaisseur est plus faible environ 10 à 50µm.

Lors d'une étape 116, un masque dur 118 (Figure 8) est déposé sur la face de la couche 22 opposée à la poignée 106. Ce masque dur est par exemple réalisé en SiO₂ ou en résine ou en Si₃N₄.

Lors d'une étape 120, le masque dur 118 est gravé, par exemple par photo-lithographie, pour délimiter l'emplacement où doivent être creusés les microcanaux 44.

Lors d'une étape 122, la gravure des microcanaux 44 débute. Pour cela, la couche 22 est gravée au travers du masque dur 118. Par exemple, la couche 22 est gravée à l'aide d'une gravure plasma appliquée à un matériau réfractaire.

Lors d'une étape 124, la gravure des microcanaux 44 dans la couche 22 est poursuivie pour que ceux-ci traversent également le substrat 6 et en particulier les régions 10 et 14 (figure 9). Par exemple, lors de cette étape, une gravure profonde RIE (Reactive Ion Etching) ou gravure ionique réactive est appliquée. Pour simplifier les figures 9 à 11 ainsi que sur les figures suivantes, un nombre limité (un seul ou deux) de microcanaux 44 est représenté.

Lors d'une étape 126, la poignée 106 est retirée, par exemple, par rodage (« grinding » en anglais) et par gravure chimique. La gravure chimique peut être réalisée avec du Tetramethylammonium hydroxide (TMAH) pour retirer le silicium et avec de l'acide fluorhydrique (HF) pour retirer l'oxyde

Lors d'une étape 128, la couche 20 de métallisation est reportée à la place de la poignée 106 sur la face supérieure de la région 10. Par exemple, la couche de métallisation 20 est collée sur cette face supérieure (figure 10). Dans ce cas, l'épaisseur de la couche 20 est typiquement supérieure à 200 µm.

Lors d'une étape 130, la gravure des microcanaux 44 est poursuivie pour que ceux-ci traversent également la couche 20 de métallisation. Une fois la gravure des microcanaux terminée, la couche 118 est retirée (figure 11).

Ensuite, Lors d'une étape 134, le substrat 6 est découpé pour séparer les différentes puces 4 simultanément fabriquées sur celui-ci afin de les individualiser.

Après, lors d'une étape 136, les différentes éléments nécessaires à l'obtention du composant 2 sont reportés sur la puce 4. En particulier, lors de l'étape 136, les pistes 24 et 26 sont déposées ou reportées sur la périphérie des couches de métallisation 20 et 22.

Toujours lors de l'étape 136, chaque puce 4 est enrobée dans un matériau d'enrobage de manière à la protéger de l'environnement extérieur afin d'obtenir le composant 2. Lors de l'enrobage, les microcanaux sont protégés pour ne pas être obstrués.

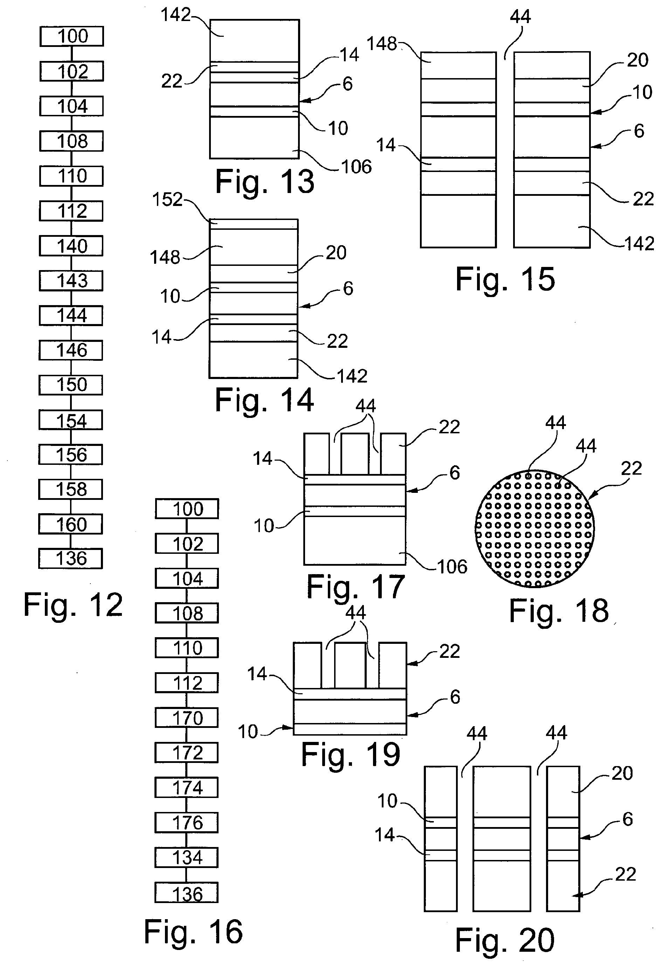

La figure 12 représente un deuxième procédé de fabrication du composant 2 et plus particulièrement de la puce 4. Ce procédé est similaire au procédé précédent à l'exception du fait que la gravure des m icrocanaux s'opère après le retrait de la poignée 106 en une seule fois. Ce procédé est retenu, par exemple, dans le cas où l'on a une couche de métal déposée plus fine qu'une plaque métallique pour former la couche de métallisation.

Ce procédé va être décrit en regard des figures 13 à 15 qui représentent des étapes particulières de ce procédé.

Seules les étapes du procédé de la figure 12 différentes de celles de la figure 5 sont décrites ici en détail. Plus précisément, ce procédé débute par les étapes 100 à 112 précédemment décrites.

L'étape 112 se poursuit par une étape 140. Lors de l'étape 140, une plaque 142 (Figure 13) en matériau conducteur ou semi-conducteur comportant sur sa face inférieure la couche de métallisation 22 est réalisée puis collée sur la région 14. Dans ce cas, l'épaisseur de la couche 22 peut être très fine (c'est-à-dire inférieure à 200 µm) et de l'ordre de quelques dizaines de micromètres. La couche 142 est par exemple réalisée en silicium.

Lors d'une étape 143, l'ensemble représenté sur la figure 13 est retourné.

Ensuite, lors d'une étape 144, la poignée 106 est retirée et un substrat 148 (Figure 14) sur lequel est déposée la couche 20 de métallisation est collée sur la région 10. De façon similaire, ce procédé permet d'avoir une couche 20 très fine simplement de l'ordre de quelques dizaines de micromètres.

Ensuite, lors d'une étape 150, un masque dur 152 (Figure 14) est déposé sur le substrat 148 du côté opposé à la couche 20. Lors de cette étape 150, ce masque dur est gravé, par exemple par photo-lithographie, pour définir l'emplacement où doivent être creusés les microcanaux 44.

Lors d'une étape 154, le masque dur 152 est utilisé pour creuser les microcanaux 44. Lors de cette étape 154, une gravure profonde RIE est par exemple réalisée.

Lors d'une étape 156, les couches 20 et 22 sont gravées à l'aide d'un procédé tel qu'une gravure plasma de matériau réfractaire.

Lors d'une étape 158, le masque 152 est retiré. On obtient alors la structure représentée sur la figure 15.

Lors d'une étape 160, les substrats 142 et 148 sont gravés pour former les pistes conductrices respectivement 24 et 26.

Ensuite, on procède à l'étape 136 sauf que les pistes 24 et 26 sont déjà réalisées.

La figure 16 représente un troisième procédé de fabrication du composant 2 et plus précisément de la puce 4. Les figures 17 à 20 représentent plus en détail différentes étapes de ce procédé.

Ce procédé débute par les étapes 100 à 112 déjà décrites en regard de la figure 5.

A l'issu de l'étape 112, lors d'une étape 170, la couche de métallisation 22 est reportée sur la région 14 (figure 17). Par exemple, la couche 22 est collée. Dans ce mode de réalisation, la couche 22 est une plaque métallique grillagée c'est-à-dire transpercée d'une multitude de trous traversants correspondant chacun à l'extrémité d'un microcanal 44. La figure 18 illustre en vue de dessus la couche 22 collée sur la région 14.

Ensuite, lors d'une étape 172, les microcanaux de la puce 4 sont gravés en utilisant comme masque les trous traversant de la couche 22.

Lors d'une étape 174, la poignée 106 est retirée (figure 19) puis l'ensemble est retourné.

Lors d'une étape 176, la couche 20 de métallisation grillagée déjà perforée d'une multitude de trous traversants est reportée sur la région 10. Lors de cette étape 176, les trous traversants de la couche 20 sont alignés avec les microcanaux 44 débouchant dans la région 10. On obtient alors la puce électronique représentée sur la figure 20.

Les étapes qui suivent sont les mêmes que celles décrites en regard de la figure 5.

Les microcanaux ont jusqu'à présent été décrits dans le cas particulier d'une diode de puissance. Toutefois, ces microcanaux peuvent être réalisés à travers les zones actives d'autres composants électroniques et en particulier d'autres composants électroniques de puissance tels que des transistors de puissance ou les LED.

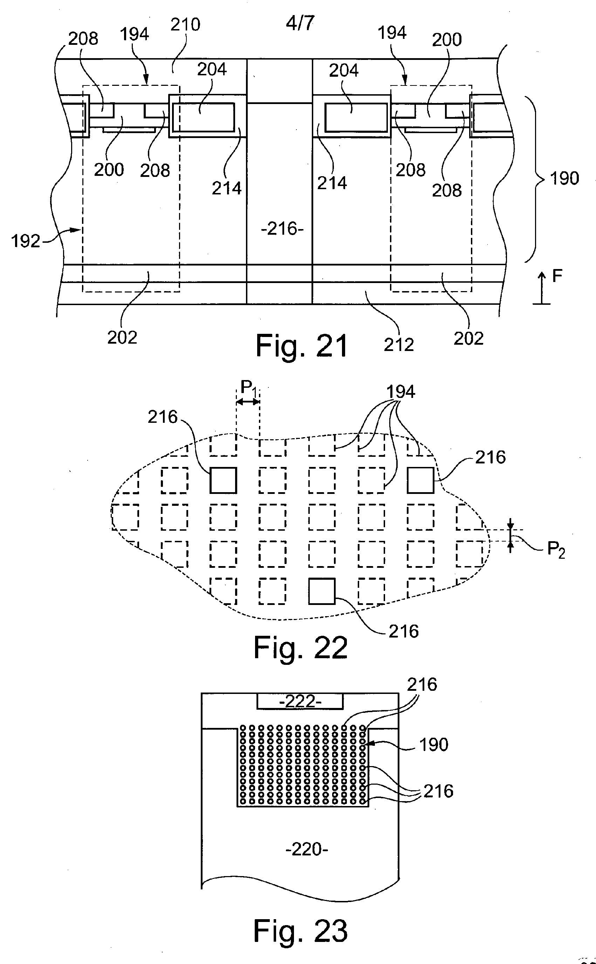

Les figures 21 et 22 représentent une portion d'une zone active 190 d'un transistor de puissance. Par exemple, le transistor de puissance est un transistor MOSFET. Ici, la zone active 190 est décrite dans le cas particulier où les grilles sont dites « enterrées ».

Cette zone active 190 comporte un substrat semi-conducteur 192 dans lequel sont réalisées une multitude de cellules 194 identiques de conduction. Pour simplifier la figure, seules deux cellules MOS 194 sont représentées sur la figure 21.

Chaque cellule 194 est formée d'une région 200 dopée de type P et d'une région 202 dopée de type N+. La région 202 est par exemple commune à l'ensemble des cellules 194 et s'étend sur toute la face inférieure de la zone active 190. A l'inverse, les régions 200 sont séparées les unes des autres par des intercellules dans lesquelles sont déposées des grilles 204.

Chaque région 200 comporte également deux sous-régions 208 dopées de type N+. Chacune des régions 200 et 208 sont directement en contact avec une couche 210 de métallisation par exemple réalisée en aluminium. De façon similaire, une couche de métallisation 212 est déposée sous la région 202. La couche 210 constitue la source du transistor tandis que la couche 212 constitue le drain de ce transistor.

Les grilles 204 situées entre deux cellules sont isolées électriquement de ces cellules et de la couche 210 par un isolant électrique 214.

Les cellules MOS sont uniformément réparties dans toute la zone active 190. Par exemple, les cellules 194 sont réparties avec des espacements réguliers, respectivement p₁ et p₂, dans deux directions non parallèles de manière à former une matrice de cellules 194 (figure 22). La section transversale de chaque cellule 194 est par exemple un carré de 20 µm de côté. Ainsi, dans le cas d'un transistor de puissance, la zone active comporte plusieurs milliers de cellules élémentaires par cm².

Des microcanaux 216 traversent la zone active 190 de part en part parallèlement à une direction F elle-même perpendiculaire au plan dans lequel s'étend l'essentiel du substrat 192.

Dans ce mode de réalisation, ces microcanaux 216 sont réalisés à l'emplacement d'une seule cellule 194, c'est-à-dire entre deux grilles 204.

De préférence, comme dans le mode de réalisation précédent, les microcanaux 216 sont uniformément répartis dans la zone active 190.

Chaque microcanal 216 vient se substituer à l'une de ces cellules élémentaires. Toutefois, le nombre de cellules élémentaires étant très nettement supérieur au nombre de microcanaux 216, le remplacement de quelques-unes de ces cellules élémentaires par des microcanaux 216 ne détériore pas le fonctionnement du transistor de puissance. Au contraire, la diminution de la zone active 190 est largement compensée par l'amélioration du refroidissement de cette zone active 190.

La figure 23 illustre en vue de dessus une piste électrique 220 venant en contact mécanique et électrique sur la majorité du pourtour de la couche 210 dans laquelle sont ménagés les microcanaux 216. Sur cette vue, une piste 222 est également raccordée aux différentes grilles 204.

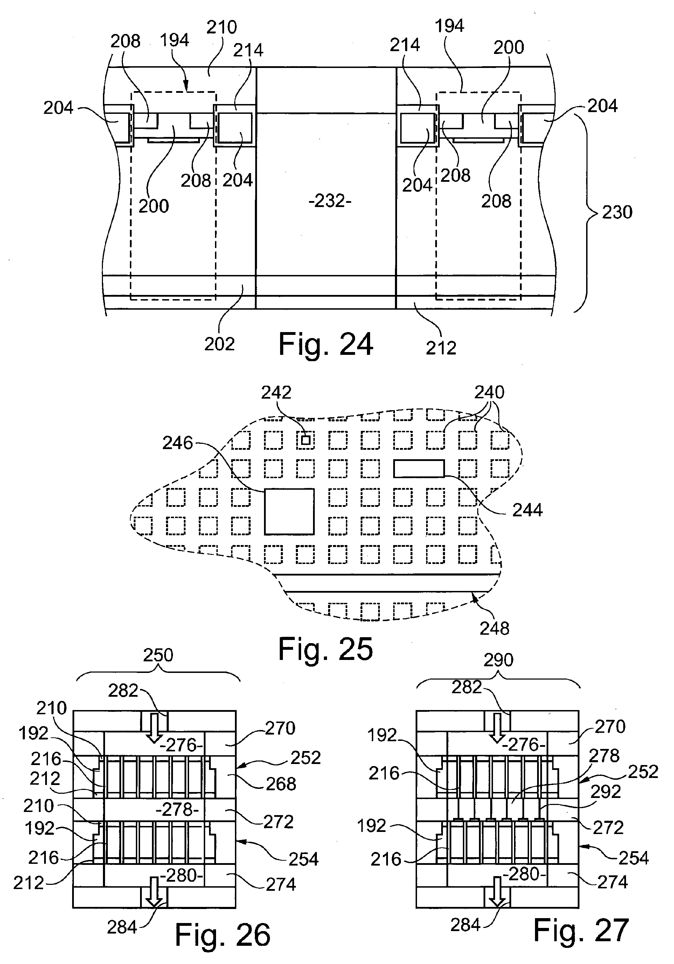

La figure 24 représente un autre mode de réalisation d'une zone active 230 d'un transistor de puissance. La zone active 230 est identique à la zone active 190 à l'exception que les microcanaux 216 sont remplacés par des microcanaux 232. La section transversale du microcanal 232 est plus large qu'une cellule 194. Il vient donc rogner une partie des grilles 204 situées de part et d'autre de la cellule 194 remplacée par le microcanal 232.

La figure 25 représente différents modes de réalisation possibles de microcanaux réalisés dans un composant électronique présentant une zone active dont la structure est similaire aux zones actives 190 et 230. Sur cette figure, les carrés en pointillée représentent des cellules MOS élémentaires 240.

Dans un premier mode de réalisation, la section transversale d'un microcanal 242 est plus petite que celle de la cellule MOS élémentaire qu'il traverse.

Dans un deuxième mode de réalisation, un microcanal 244 présente une section transversale qui s'étend sur plusieurs cellules 240. Par exemple, le microcanal 244 remplace deux cellules élémentaires 240.

Dans un troisième mode de réalisation, un microcanal 246 remplace plusieurs cellules 240 dans deux directions orthogonales. Par exemple ici, le microcanal 246 remplace un carré de quatre cellules 240.

Enfin, dans un quatrième mode de réalisation, la section transversale d'un microcanal 248 remplace une ligne ou une colonne entière de cellules 240.

Un seul de ces modes de réalisation des microcanaux peut être appliqué à la fois dans un composant électronique ou, au contraire, ces différents modes de réalisation peuvent être combinés au sein d'une même zone active.

La figure 26 représente un composant électronique 250 ayant une structure dite « 3D ». Un composant électronique ayant une structure 3D est un composant comportant plusieurs puces électroniques empilées les unes au-dessus des autres et contenues dans un même boîtier. L'empilement des puces électroniques les unes au-dessus des autres améliore la compatibilité électromagnétique. Toutefois, l'empilement des puces électroniques les unes sur les autres au sein d'un même composant électronique pose des problèmes particulièrement critiques de refroidissement. En effet, les zones situées entre ces puces électroniques sont difficiles d'accès et donc particulièrement difficiles à refroidir.

Ici, le composant électronique 250 est décrit dans le cas particulier où il s'agit d'un bras de commutation, par exemple, un bras d'onduleur. Un tel bras de commutation est formé de deux interrupteurs commandables raccordés en série par l'intermédiaire d'un point milieu. Ici, chaque interrupteur commandable est réalisé par une puce électronique 252, 254 respective.

Les puces 252 et 254 sont, chacune, réalisées de façon identique à ce qui a été décrit précédemment en regard des figures 21 à 25. Celles-ci ne sont pas décrites ici plus en détail.

La puce 252 est empilée au-dessus de la puce 254. Sa source 210 est raccordée à une piste conductrice 270.

Le drain 212 de la puce 252 et la source 210 de la puce 254 sont électriquement raccordés à la même piste électrique 272 qui forme le point milieu du bras de commutation.

Le drain 212 de la puce 254 est raccordé à la piste électrique 274.

Comme décrit en regard de la figure 21, les microcanaux 216 débouchent de part et d'autre de chaque puce dans des collecteurs 276, 278 et 280.

Le collecteur 278 est situé entre les puces 252 et 254 et se retrouve coincé entre les substrats 192 de chacune de ces puces. Le collecteur 276 reçoit par l'intermédiaire d'un orifice 282 le fluide caloporteur froid tandis que le collecteur 280 refoule le fluide caloporteur réchauffé par les puces 252 et 254 par l'intermédiaire d'un orifice 284.

Dans ce mode de réalisation, les microcanaux 216 qui traversent les puces 252 et 254 sont alignés les uns sur les autres.

Un tel assemblage des puces 252 et 254 permet d'obtenir un composant électrique à structure 3D efficacement refroidi. On obtient donc l'avantage d'améliorer la compatibilité électromagnétique sans pour autant présenter les inconvénients liés à un refroidissement peu efficace.

La figure 27 représente un composant électrique 290 à structure 3D identique au composant 250 à l'exception que les microcanaux des puces 252 et 254 ne sont pas alignés les uns en faces des autres. Ainsi, les microcanaux 216 de la puce 252 produisent un jet 292 qui vient heurter la face supérieure de la couche 210 de métallisation de la puce 254. Ce jet permet d'obtenir un refroidissement plus efficace.

Sur les figures 26 et 27, les flèches représentent la direction d'écoulement du fluide caloporteur.

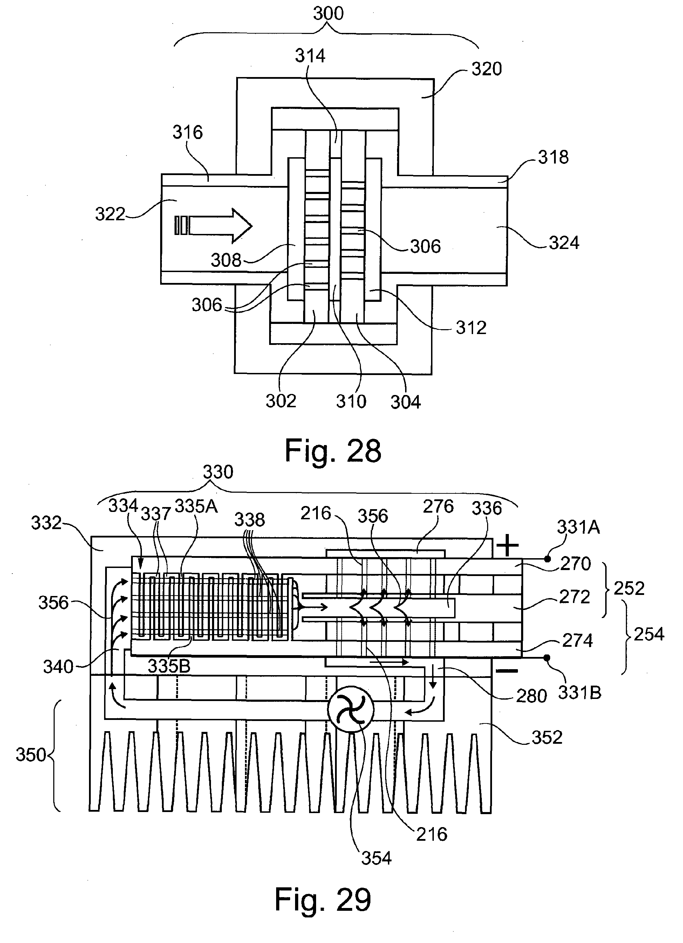

La figure 28 représente un composant électronique 300 comprenant deux puces électroniques 302, 304 empilées l'une au-dessus de l'autre. Ces puces 302, 304 sont réalisées conformément aux enseignements donnés ci-dessus et sont donc notamment traversées par des microcanaux 306. Les microcanaux 306 de la puce 302 débouchent d'un côté dans un collecteur d'admission 308 et de l'autre côté dans un collecteur intermédiaire 310. Les microcanaux 306 de la puce 304 débouchent d'un côté dans la chambre intermédiaire 310 et de l'autre côté dans un collecteur d'échappement 312.

Les puces 302 et 304 sont électriquement raccordées en série par l'intermédiaire de leur périphérie extérieure. A cet effet, une piste électrique 314 relie la périphérie extérieure de la puce 302 à la périphérie extérieure de la puce 304 immédiatement dessous.

Le composant 300 comporte également une piste 316 d'amenée de courant électrique et une piste 318 de collecte du courant électrique. Ces pistes 316 et 318 ont des extrémités qui forment des broches en saillie au-delà d'un boîtier 320 en polymère enrobant les puces 302 et 304 ainsi que les différents collecteurs.

La piste 316 est électriquement raccordée à la périphérie de la zone active de la puce 302 tandis que la piste 318 est électriquement raccordée à la périphérie de la zone active de la puce 304. Ces pistes 316 et 318 assurent donc le raccordement électrique des puces 302 et 304 à un circuit électrique extérieur au boîtier 320.

Ici, ces pistes 316 et 318 sont évidées à l'intérieur pour former un tube creux. La piste 316 présente un creux 322 fluidiquement raccordé au collecteur d'admission 308 tandis que la piste 318 présente un creux 324 fluidiquement raccordé au collecteur d'échappement 312.

Sur la figure 28, la flèche à l'intérieur du creux 322 représente la direction d'écoulement du fluide caloporteur.

Ainsi, dans ce mode de réalisation, les broches de connexion électrique des puces électroniques servent également de conduit de raccordement fluidique des microcanaux 306 à un circuit de refroidissement extérieur au boîtier 320.

La figure 29 représente un bras de commutation 330 électriquement raccordé entre des broches 331 A et 331 B d'entrée et de sortie de tension. Ce bras est par exemple identique au bras 250 à l'exception du fait qu'il incorpore à l'intérieur d'un boîtier en polymère 332 non seulement les puces 252 et 254 empilées l'une au-dessus de l'autre mais aussi un condensateur 334 de découplage. De plus, dans le bras 330, la chambre 278 est remplacée par un collecteur 336 qui débouche sur une face du condensateur 334.

Le condensateur 334 est typiquement formé de deux broches conductrices 335A et 335B en regard l'une de l'autre et isolées électriquement l'une de l'autre par un matériau diélectrique 337. Le condensateur 334 est traversé par une multitude de microcanaux 338. Ces microcanaux 338 débouchent d'un côté dans la chambre 336 et de l'autre côté dans un collecteur d'admission 340. Ici, ces microcanaux 338 traversent les broches 335A, 335B et le matériau diélectrique 337.

Le collecteur d'admission 340 et le collecteur d'échappement 280 sont fluidiquement raccordés à un circuit de refroidissement 350. Le circuit 350 comporte un échangeur thermique 352 et une pompe 354. L'échangeur thermique 352 est par exemple un radiateur qui permet de refroidir le fluide caloporteur qui s'échappe du collecteur 280 avant de le réinjecter dans la chambre 340. La pompe 354 permet de faire circuler le fluide caloporteur dans le circuit de refroidissement. Ici, la circulation du fluide caloporteur est représentée par des flèches 356.

Le condensateur 334 est raccordé entre les pistes 270 et 274 à proximoté des puces pour éliminer les surtensions causées par l'inductance parasites des conducteurs électriques qui raccordent le composant 330 à une source de tension lors des commutations des puces 252 et 254. Ici, la source de tension est appliquée entre les bornes 331A, 331 B, électriquement raccordées, respectivement, aux pistes 270, 274.

Les microcanaux du condensateur 354 sont fluidiquement raccordés aux microcanaux 216 des puces 252 et 254 de manière à recevoir le fluide caloporteur avant les puces 252, 254. Ainsi, le condensateur 334 peut être placé au plus près des interrupteurs, ce qui améliore le filtrage des surtensions. De plus, grâce aux microcanaux, le condensateur peut fonctionner même en étant très proche des puces 252 et 254 car la température reste faible c'est-à-dire par exemple inférieure à 100°C ou 80 °C. De plus, dans ce mode de réalisation, le circuit de refroidissement est intégré au composant électronique 330, c'est-à-dire qu'il fait partie du même boîtier 332.

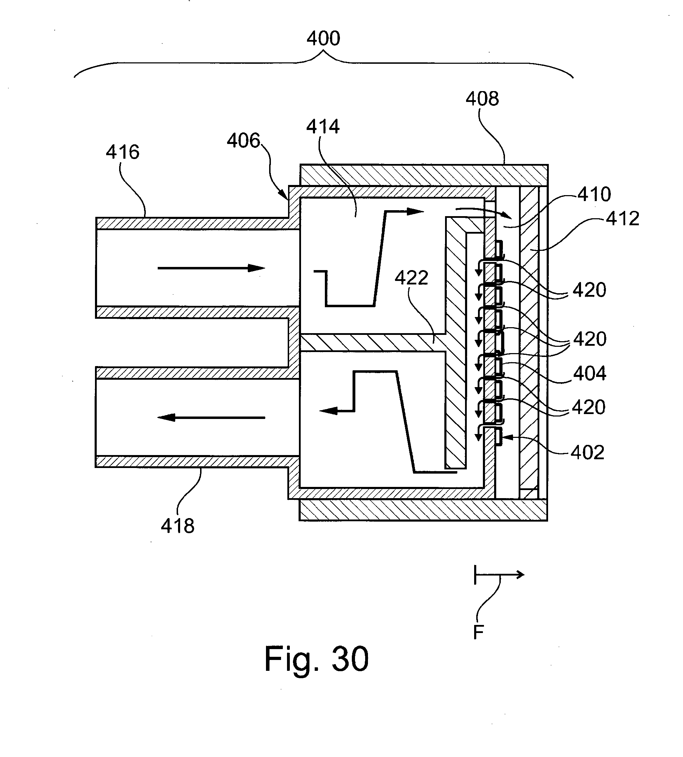

La figure 30 représente une lampe 400. La lampe 400 est un composant électronique qui transforme une partie de l'énergie électrique qu'il reçoit en photons et donc en lumière. A cet effet, la lampe 400 comporte un substrat semi-conducteur 402 dans lequel sont réalisées une où plusieurs LED (Light Emitting Diode) 404. Les LED sont bien connues et seules les informations nécessaires à la mise en oeuvre du refroidissement des zones actives des LED sont données. Pour plus d'informations sur les autres caractéristiques de la lampe 400 décrite ici, il est possible de se référer à la demande de brevet WO2005089477.

Chaque LED 404 comprend une zone active principalement formée par une jonction P-N dont le rôle est de générer des photons lorsque la zone active est traversée par le courant utile. Cette zone active, comme les précédentes, commute entre un état passant et un état non passant en réponse à un signal de commande. Ici, comme pour la diode de la figure 1, le signal de commande est la tension appliquée entre les bornes de la lampe 400. Toutefois, contrairement aux composants électroniques utilisés comme interrupteur, dans l'état non passant, la LED n'a qu'une faible tenue à la tension, par exemple, de l'ordre que quelques volts.

Les LED 404 sont montées dans un boîtier 406 qui inclut un couvercle 408 pour enfermer hermétiquement le substrat 402 à l'intérieur d'une cavité 410. Le couvercle 408 comprend une fenêtre 412. La fenêtre 412 peut comprendre des éléments optiques, tel qu'un réseau d'éléments de diffraction ou de réflexion, pour collecter et collimater la lumière émise par chaque LED sur une surface. Le substrat 402 est monté à l'intérieur de la cavité 410 de manière à ce que ses faces supérieure et inférieure soient exposées à un fluide caloporteur 414 qui circule dans la cavité 410. Sur la figure 30 le sens de circulation du fluide 414 est représenté par des flèches.

Dans ce mode de réalisation, le fluide 414 est admis dans la cavité 410 par l'intermédiaire d'un canal d'admission 416 et refoulé de cette cavité par un canal d'échappement 418.

Comme dans les modes de réalisation précédents, la zone active de chaque LED est traversée par des m icrocanaux 420 sensiblement perpendiculairement au plan du substrat 402.

Enfin, la lampe 400 comporte aussi une paroi 422 conformée pour obliger l'écoulement du fluide 414 à traverser la zone active de la LED par l'intermédiaire des microcanaux 420. Ainsi, le refroidissement de chaque LED est amélioré.

De nombreux autres modes de réalisation dans les limites définies par les revendications sont possibles. Par exemple, d'autres échangeurs thermiques qu'un radiateur sont possibles. En particulier, l'échangeur thermique peut être un échangeur thermique échangeant des calories entre le fluide caloporteur d'un côté et un liquide ambiant.

La couche de passivation des flancs des microcanaux peut être omise.

L'évasement de la section transversale des microcanaux peut également être omis.

La section transversale des microcanaux peut être dix, cent ou mille fois plus longue que large.

La puce électronique peut être n'importe quel interrupteur commandable tel qu'une diode, un transistor MOS, un transistor GTO, un thyristor, un HEMT (High Electron Mobility Transistor), un triac ou autre. In peut aussi s'agir d'une LED.

Les puces peuvent être en silicium ou en nitrure de gallium ou dans d'autres matériaux semi-conducteurs.

Pour chaque puce électronique, le type de dopant peut être inversé. Ainsi, les régions dopées de type N peuvent être remplacées par des régions dopées de type P et vice versa.

Lorsque la section transversale du microcanal s'évase, la plus grande largeur de la section transversale du microcanal peut augmenter linéairement ou au contraire non linéairement tel que par exemple exponentiellement. La plus grande largeur de la section transversale du microcanal peut également s'évaser par palier ou sur une portion seulement de la longueur du microcanal.

Les microcanaux peuvent être non uniformément répartis dans la zone active. Par exemple, la densité de microcanaux est plus importante dans une région spécifique de la zone active connue pour s'échauffer plus que les autres. Par densité de microcanaux, on désigne le nombre de microcanaux traversant la zone active par cm².

La couche de passivation peut être appliquée uniquement au niveau où le microcanal traverse l'interface entre deux régions dopées de types différents.

La zone périphérique entourant la zone active peut être omise si les tensions en jeu sont suffisamment faibles.

Les couches de métallisation peuvent être réalisées à l'aide de couches de métallisation poreuses obtenues en déposant sur les faces supérieure et inférieure de la zone active un matériau perméable dépourvu de canaux s'étendant uniquement dans une direction perpendiculaire au plan du substrat. Par exemple, ce matériau perméable est un matériau granulaire. Un tel matériau granulaire est par exemple formé d'une multitude de petits grains en matériau conducteur en contact électrique les uns avec les autres. II existe entre ces grains des interstices à travers lesquels le fluide caloporteur peut passer pour traverser de part en part la couche de métallisation. Par exemple, le matériau granulaire est un fritté de cuivre. Le matériau perméable peut également être une mousse telle qu'une mousse de fer ou une fibre.

Le diamètre hydraulique des trous ménagés dans la couche de métallisation pour la rendre perméable au fluide caloporteur peut être plus grand que le diamètre hydraulique des microcanaux tranversant la zone active.

Les couches de métallisation et les pistes électriques en contact avec ces couches peuvent être formées dans un même bloc de matière. Par exemple, une couche métallique de l'épaisseur des pistes électriques est déposée sur la zone active et sa périphérie. La partie de cette piste électrique à l'aplomb de la zone active est transpercée de microcanaux qui prolongent, au travers de ces pistes, les microcanaux qui traversent la zone active pour les faire déboucher sur la face extérieure de la couche métallique du côté opposé au substrat.

Le contact entre les pistes 24, 26 et les couches 20,22 peut également être de type encastré, par exemple, par soudure ou brasure.

En variante, la piste 24 ou 26 est réalisée par un ou plusieurs des fils de contact qui raccordent électriquement la couche de métallisation à d'autres pistes électriques. Ces fils de contact sont connus sous le terme anglais de « bonding wires ». Ils sont par exemple en aluminium ou en or. De préférence, ils raccordent la couche de métallisation supérieure (par exemple la couche 20) à des pistes électriques gravées sur un substrat sur lequel est déposé la puce.

En variante, le microcanal traverse de part en part la grille.

Ce qui a été décrit ci-dessus s'applique également à des transistors ayant des grilles non enterrées.

Lorsque le substrat est suffisamment épais pour des raisons de caractéristiques électriques, la mise en oeuvre d'une poignée est omise dans le procédé de fabrication des puces.

Les étapes de collage des couches de métallisation peuvent être remplacées par des étapes de dépôts de matériaux électriquement conducteurs. Par exemple, ces matériaux sont déposés par électrolyse.

Ce qui a été décrit ci-dessus s'applique au composant de puissance latéral ayant toutes ses électrodes d'un même côté du substrat.

L'enseignement donné ici s'applique aussi à des composants électroniques comportant plusieurs puces électroniques disposées les une à côté des autres dans un même plan. Par exemple, dans ce cas, les extrémités des microcanaux de chaque puce débouchent de part et d'autre dans un collecteur commun, respectivement, d'admission et d'échappement.

Un composant électronique à structure 3D comme décrit en regard des figures 26, 27 et 28 n'est pas nécessairement réalisé qu'avec des transistors. Il peut être réalisé en empilant n'importe quelle puce électronique les unes sur les autres comme une diode, un thyristor ou autres.

En variante, les microcanaux 338 lèchent la face des électrodes du condensateur de découplage mais ne traversent pas ses électrodes ou le matériau diélectrique présent entre ses électrodes. Le circuit de refroidissement du condensateur de découplage peut également être fluidiquement indépendant de celui des interrupteurs commandables.

Le fluide caloporteur peut être un liquide diélectrique ou un gaz diélectrique. Le liquide ou le gaz peut être utilisé à une pression importante.

Le fluide caloporteur n'a pas besoin d'être dielectrique si une couche d'isolant électrique l'isole électriquement des matériaux conducteurs de la puce.

Le fluide caloporteur peut circuler dans le sens indiqué sur les figures ou en sens opposé.

Le fluide caloporteur peut être utilisé, dans des cas particuliers, également pour réchauffer la puce électronique.

## Revendications

1. Puce électronique comportant :
- un substrat semi-conducteur (6; 192; 402) s'étendant essentiellement dans un plan et présentant une zone active (8; 190; 230) formée d'au moins une région dopée de type P et d'au moins une région dopée de type N qui forment une ou plusieurs jonctions P-N par l'intermédiaire desquelles passe l'essentiel du courant utile lorsque cette puce électronique est dans un état passant, et
- au moins un canal (44; 216; 232; 242; 244; 246; 248) apte à recevoir l'écoulement d'un fluide caloporteur, le ou les canaux traversant au moins ladite région dopée de type P ou N de la zone active,
ledit au moins un canal (44; 216; 232; 242; 244; 246; 248) étant rectiligne et traversant de part en part le substrat (6 ; 192 ; 402) dans une direction colinéaire avec une direction F à ± 45° près, où la direction F est perpendiculaire au plan du substrat.

2. Puce selon la revendication 1, dans laquelle la puce comporte une première et une seconde couches (20, 22; 210, 212) de métallisation qui s'étendent uniformément directement sur des faces opposées respectives de la zone active de manière à répartir le courant utile dans la section transversale de la zone active, chaque couche de métallisation étant perméable au fluide caloporteur et traversée de part en part par le fluide caloporteur qui s'écoule dans le ou les canaux qui débouchent dans la zone active.

3. Puce selon l'une quelconque des revendications précédentes, dans laquelle la puce comporte plus de cent canaux traversant la région dopée de type N ou P de la zone active.

4. Puce selon la revendication 3, dans laquelle le cumul des surfaces des sections transversales des canaux (44; 216; 232; 242; 244; 246; 248) est au moins inférieure au tiers de la surface de la zone active.

5. Puce selon l'une quelconque des revendications précédentes, dans laquelle le canal (44) s'évase dans la région la moins dopée en allant de la région la plus dopée vers la région la moins dopée.

6. Puce selon l'une quelconque des revendications précédentes, dans laquelle les flancs du canal (44) sont recouverts d'une couche (54) en matériau diélectrique au moins au niveau où il traverse l'intersection entre deux régions dopées de types différents.

7. Puce selon la revendication 2 ou l'une quelconque des revendications 3 à 6 si elle est dépendante de la revendication 2 dans laquelle l'épaisseur e de la couche (20, 22; 210, 212) de métallisation est telle que le ratio p/e est inférieur à 0,1 mΩ, où p est la conductivité ohmique du matériau dans lequel est réalisé la couche de métallisation.

8. Puce selon l'une quelconque des revendications précédentes, dans laquelle :
- la zone active (190; 230) est formée d'une vaste région dopée de type P ou N à l'intérieur de laquelle sont implantées des cellules élémentaires (200) dopées de type opposé pour former de multiples jonctions P-N entre lesquelles sont disposées des grilles conductrices (204) propres à faire commuter la zone active entre un état passant et un état non passant, et
- chaque canal (216; 232) traverse ou occupe la place d'une cellule élémentaire située entre deux grilles.

9. Puce selon l'une quelconque des revendications précédentes, dans laquelle la puce est un interrupteur commandable apte à commuter, en réponse à un signal de commande, la zone active entre un état passant où elle oppose une faible résistance au passage du courant et un état non passant où elle oppose une résistance au moins dix fois supérieure au passage du courant.

10. Puce selon l'une quelconque des revendications précédentes, dans laquelle le plus petit diamètre hydraulique du ou des canaux est compris entre 1 et 500 µm.

11. Composant électronique, **caractérisé en ce que** le composant comporte:
- une puce (4; 252, 254; 302, 304) conforme à l'une quelconque des revendications précédentes, dans laquelle la puce comporte au moins une couche (20, 22; 210, 212) de métallisation qui s'étend uniformément directement sur une face de la zone active, cette couche de métallisation étant perméable au fluide caloporteur qui s'écoule dans le ou les canaux qui débouchent dans la zone active, et
- au moins une piste conductrice (24, 26; 220) uniquement répartie sur la périphérie de la zone active et directement en contact mécanique et électrique avec la couche de métallisation pour amener ou collecter le courant qui traverse cette zone active lorsque la puce électronique est passante, le contact électrique entre la piste conductrice (24, 26; 220) et la couche (20, 22; 210, 212) de métallisation étant assuré uniquement par un contact pressé sans soudure ou collage apte à permettre un glissement de la piste électrique sur la couche de métallisation en réponse à chaque variation de température.

12. Composant selon la revendication 11, dans lequel ladite au moins une piste conductrice est une bronche (316, 318) en forme de tube creux en matériau électriquement conducteur dont la périphérie est électriquement raccordée à la périphérie de la zone active de la puce électronique et dont le creux (322, 324) est fluidiquement raccordé audit au moins un canal (306) qui traverse la zone active.

13. Composant électronique à structure 3D comportant :
- au moins une première et une seconde puces électroniques (252, 254) présentant chacune une face supérieure et une face inférieure, ces puces électroniques étant empilées l'une au-dessus de l'autre de manière à ce que la face supérieure de la première puce électronique soit en vis-à-vis de la face inférieure de la seconde puce électronique,
**caractérisé en ce que** :
- les première et seconde puces électroniques (252, 254) sont conformes à l'une quelconque des revendications 1 à 10 précédentes et des extrémités supérieures du ou des canaux (216) qui débouchent dans la face supérieure de la première puce électronique sont fluidiquement raccordées à des extrémités inférieures du ou des canaux qui débouchent dans la face inférieure de la seconde puce électronique, et
- les faces supérieure et inférieure des première et seconde puces (252, 254) définissent les parois supérieure et inférieure d'un collecteur intermédiaire (278) de fluide caloporteur logé entre les première et seconde puces électroniques et dans lequel débouchent les extrémités supérieures des canaux (216) de la première puce électronique et les extrémités inférieures des canaux de la seconde puce électronique.

14. Composant selon la revendication 13, dans lequel :
- les première et seconde puces électroniques (252, 254) comportent chacune au moins une couche (210, 212) de métallisation qui s'étend uniformément directement sur une face, respectivement inférieure et supérieure, de la zone active, cette couche de métallisation étant perméable au fluide caloporteur qui s'écoule dans le ou les canaux qui débouchent dans la zone active, et
- au moins une piste conductrice commune (272) uniquement répartie sur la périphérie de la zone active de chaque puce et directement en contact mécanique et électrique avec les couches de métallisation qui s'étendent sur la face inférieure de la zone active de la première puce et sur la face supérieure de la zone active de la seconde puce pour amener ou collecter le courant qui traverse ces zones actives .

15. Bras de commutation comportant :
- des bornes (331 A, 331 B) d'entrée et de sortie de tension,
- au moins deux interrupteurs commandables (252, 254) raccordés en série entre ces bornes d'entrée et de sortie, et
- au moins un condensateur (334) de découplage équipé d'au moins deux électrodes raccordées électriquement, respectivement, aux bornes d'entrée et de sortie, et d'un matériau diélectrique isolant électriquement ces deux électrodes l'une de l'autre, **caractérisé en ce que** chaque interrupteur commandable (252, 254) comprend une puce électronique conforme à l'une quelconque des revendications 1 à 10, et le condensateur de découplage (334) comprend au moins un canal (338) qui traverse le matériau diélectrique entre les électrodes ou qui s'étend directement le long d'au moins l'une des électrodes, ce ou ces canaux étant fluidiquement raccordés aux canaux (216) traversant les zones actives des puces électroniques formant les interrupteurs commandables.

## Patentansprüche

1. Elektronischer Chip, umfassend:
- ein Halbleitersubstrat (6; 192; 402), das sich im Wesentlichen in einer Ebene erstreckt und eine aktive Zone (8; 190; 230) aufweist, die aus mindestens einem dotierten P-Bereich und mindestens einem dotieren N-Bereich gebildet ist, die eine oder mehrere P-N-Übergänge bilden, durch die der Großteil des Nutzstroms geleitet wird, wenn sich dieser elektronische Chip in einem leitenden Zustand befindet, und
- mindestens einen Kanal (44; 216; 232; 242; 244; 246; 248), mit Durchfluss für ein Kühlmittel, wobei der oder die Kanäle mindestens den dotierten P- oder N-Bereich der aktiven Zone durchqueren,
wobei mindestens ein Kanal (44; 216; 232; 242; 244; 246; 248) geradlinig ist und das gesamte Substrat (6; 192; 402) in einer Richtung durchquert, die zur Richtung F zu ungefähr ± 45° kollinear ist, wobei sich die Richtung F senkrecht zur Ebene des Substrats befindet.

2. Chip nach Anspruch 1, wobei der Chip eine erste und eine zweite Metallisierungsschicht (20, 22; 210, 212) umfasst, die sich gleichmäßig direkt auf jeweils gegenüberliegenden Seiten der aktiven Zone erstrecken, um den Nutzstrom im Querschnitt der aktiven Zone zu verteilen, wobei jede Metallisierungsschicht für das Kühlmittel durchlässig ist und von dem Kühlmittel vollständig durchquert wird, das in dem oder den Kanälen fließt, die in der aktiven Zone münden.

3. Chip nach einem der vorhergehenden Ansprüche, wobei der Chip mehr als hundert Kanäle umfasst, die den dotierten N- oder P-Bereich der aktiven Zone durchqueren.

4. Chip nach Anspruch 3, wobei die Gesamtsumme der Oberflächen der Querschnitte der Kanäle (44; 216; 232; 242; 244; 246; 248) mindestens kleiner ist als das Drittel der Oberfläche der aktiven Zone.

5. Chip nach einem der vorhergehenden Ansprüche, wobei sich der Kanal (44) in den am wenigsten dotierten Bereich erweitert, indem er vom am stärksten dotierten Bereich zum am wenigsten dotierten Bereich verläuft.

6. Chip nach einem der vorhergehenden Ansprüche, wobei die Seiten des Kanals (44) mindestens in der Höhe, in der er den Schnittpunkt von zwei dotierten Bereichen verschiedenen Typs durchquert, mit einer Schicht (54) aus dielektrischem Material bedeckt sind.

7. Chip nach Anspruch 2 oder nach einem der Ansprüche 3 bis 6, wenn er von Anspruch 2 abhängig ist, wobei die Dicke e der Metallisierungsschicht (20, 22; 210, 212) so ist, dass das Verhältnis p/e kleiner als 0,1 mΩ ist, worin p die ohmsche Leitfähigkeit des Materials ist, aus dem die Metallisierungsschicht ausgeführt ist.

8. Chip nach einem der vorhergehenden Ansprüchen, wobei:
- die aktive Zone (190; 230) aus einem breiten dotierten P- oder N-Bereich gebildet ist, in dessen Innerem dotierte Elementarzellen (200) gegensätzlichen Typs integriert sind, um mehrere P-N-Übergänge zu bilden, zwischen denen leitende Gitter (204) angeordnet sind, die geeignet sind, die aktive Zone zwischen einem leitenden Zustand und einem nicht leitenden Zustand kommutieren zu lassen, und
- wobei jeder Kanal (216; 232) den Platz einer Elementarzelle, die zwischen zwei Gittern liegt, durchquert oder einnimmt.

9. Chip nach einem der vorhergehenden Ansprüche, wobei der Chip ein steuerbarer Schalter ist, der als Reaktion auf ein Steuersignal die aktive Zone zwischen einem leitenden Zustand, in dem sie dem Stromdurchfluss einen geringen Widerstand entgegensetzt, und einem nicht leitenden Zustand, in dem sie dem Stromdurchfluss einen mindestens zehn mal größeren Widerstand entgegensetzt, kommutieren kann.

10. Chip nach einem der vorhergehenden Ansprüche, wobei der kleinste hydraulische Durchmesser des oder der Kanäle im Bereich zwischen 1 und 500 µm liegt.

11. Elektronische Komponente, **dadurch gekennzeichnet, dass** die Komponente Folgendes umfasst:
- einen Chip (4; 252, 254; 302, 304) nach einem der vorhergehenden Ansprüche, wobei der Chip mindestens eine Metallisierungsschicht (20, 22; 210, 212) umfasst, die sich gleichmäßig direkt auf einer Seite der aktiven Zone erstreckt, wobei diese Metallisierungsschicht für das Kühlmittel durchlässig ist, das in dem oder den Kanälen fließt, die in der aktiven Zone münden, und
- mindestens eine Leiterbahn (24, 26; 220), die nur auf dem Rand der aktiven Zone verteilt ist und direkt in mechanischem und elektrischem Kontakt mit der Metallisierungsschicht ist, um den Strom zuzuführen oder zu sammeln, der diese aktive Zone durchquert, wenn der elektronische Chip leitend ist, der elektrische Kontakt zwischen der Leiterbahn (24, 26; 220) und der Metallisierungsschicht (20, 22; 210, 212) wird nur durch einen Druckkontakt ohne Naht oder Kleben gewährleistet, der geeignet ist, ein Gleiten der elektrischen Bahn auf der Metallisierungsschicht als Reaktion auf jede Temperaturvariation zu ermöglichen.

12. Komponente nach Anspruch 11, wobei die mindestens eine Leiterbahn ein Pin (316, 318) in Form eines Hohlrohrs aus elektrisch leitendem Material ist, dessen Rand elektrisch an den Rand der aktiven Zone des elektronischen Chips angeschlossen ist und dessen Hohlraum (322, 324) fluidisch an den mindestens einen Kanal (306) angeschlossen ist, der die aktive Zone durchquert.

13. Elektronische Komponente mit 3D-Struktur, umfassend:
- mindestens einen ersten und einen zweiten elektronischen Chip (252, 254), die jeweils eine Oberseite und eine Unterseite aufweisen, wobei diese elektronischen Chips übereinander gestapelt sind, so dass sich die Oberseite des ersten elektronischen Chips gegenüber der Unterseite des zweiten elektronischen Chips befindet,
**dadurch gekennzeichnet, dass**:
- der erste und der zweite elektronische Chip (252, 254) gemäß einem der vorhergehenden Ansprüche 1 bis 10 sind und obere Enden des oder der Kanäle (216), die in der Oberseite der ersten elektronischen Chips münden, fluidisch an unteren Enden des oder der Kanäle, die in der Unterseite des zweiten elektronischen Chips münden, angeschlossen sind und
- die Ober- und Unterseiten des ersten und zweiten Chips (252, 254) die oberen und unteren Wände eines dazwischen liegenden Kühlmittelsammlers (278) definieren, der zwischen dem ersten und dem zweiten elektronischen Chip angeordnet ist, und in dem die oberen Enden der Kanäle (216) des ersten elektronischen Chips und die unteren Enden der Kanäle des zweiten elektronischen Chips münden.

14. Komponente nach Anspruch 13, wobei:
- der erste und der zweite elektronische Chip (252, 254) jeweils mindestens eine Metallisierungsschicht (210, 212) umfassen, die sich gleichmäßig direkt auf jeweils einer Unter- und Oberseite der aktiven Zone erstreckt, wobei diese Metallisierungsschicht für das Kühlmittel durchlässig ist, das in dem oder den Kanälen fließt, die in der aktiven Zone münden, und
- mindestens eine gemeinsame Leiterbahn (272) nur auf dem Rand der aktiven Zone jedes Chips verteilt ist und direkt in mechanischem und elektrischem Kontakt mit den Metallisierungsschichten ist, die sich auf der Unterseite der aktiven Zone des ersten Chips und auf der Oberseite der aktiven Zone des zweiten Chips erstrecken, um den Strom zuzuführen oder zu sammeln, der diese aktiven Zonen durchquert.

15. Kommutierungsvorrichtung, umfassend:
- Spannungseingangs- und Spannungsausgangsanschlüsse (331A, 331B),
- mindestens zwei steuerbare Schalter (252, 254), die in Reihe zwischen diesen Eingangs- und Ausgangsanschlüssen angeschlossen sind, und
- mindestens einen Blockkondensator (334), der mit mindestens zwei Elektroden, die elektrisch jeweils an den Eingangs- und Ausgangsanschlüssen angeschlossen sind und einem dielektrischen Material ausgestattet ist, das diese beiden Elektroden elektrisch voneinander isoliert, **dadurch gekennzeichnet, dass** der steuerbare Schalter (252, 254) einen elektronischen Chip gemäß einem der Ansprüche 1 bis 10 und der Blockkondensator (334) mindestens einen Kanal (338) umfasst, der das dielektrische Material zwischen den Elektroden durchquert oder der sich direkt entlang mindestens einer der Elektroden erstreckt, wobei dieser oder diese Kanäle fluidisch an die Kanäle (216) angeschlossen (ist) sind, die die aktiven Zonen der elektronischen Chips durchqueren, die die steuerbaren Schalter bilden.

## Claims

1. An electronic chip comprising:
- a semiconductor substrate (6; 192; 402) extending essentially in a plane and presenting an active zone (8; 190; 230) formed by at least one p-doped region and at least one n-doped region that form one or more p-n junctions through which useful current flows when this first electronic chip is in an "on" state, and
- at least one channel (44; 216; 232; 242; 244; 246; 248) able to receive the flow of a heat-transfer fluid, the channel or channels traversing at least said p-doped region or said n-doped region of the active zone,
- said at least one channel (44; 216; 232; 242; 244; 246; 248) being rectilinear and traversing the substrate (6; 192; 402) in a collinear direction with a direction F that is ± 45 degrees, where the direction F is perpendicular to the substrate plane.

2. The chip according to claim 1, in which the chip comprises first metallization and second metallization layers (20, 22; 210, 212) that extend uniformly directly on respective opposite faces of the active zone so as to distribute useful current in a cross-section of the active zone, each metallization layer being permeable to the heat-transfer fluid and traversed by the heat-transfer fluid that flows through the channel (s) that open (s) into the active zone.

3. The chip according to any one of the previous claims, in which the chip comprises more than one hundred channels traversing the n-doped or p-doped region of the active zone.

4. The chip according to claim 3, in which the total sum of the cross-sectional areas of all the channels (44; 216; 232; 242; 244; 246; 248) is at least less than a third of the area of the active zone.

5. The chip according to any one of the previous claims, in which the channel (44) is flared in a least-doped region by going from a most-highly-doped region to the least-doped region.

6. The chip according to any one of the previous claims, in which the sides of the channel (44) are covered with a layer (54) of dielectric material at least at a level at which the side crosses an intersection between two doped regions of different types.

7. The chip according to claim 2 or any one of claims 3 to 6 if the claim is dependent from claim 2, in which a thickness e of the metallization layer (20, 22; 210, 212) is such that a p/e ratio is less than 0.1 mΩ, where p is the Ohmic conductivity of the material in which the metallization layer is made.

8. The chip according to any one of the previous claims, in which:
- the active zone (190; 230) is formed from a vast p-doped region or n-doped region in which elementary cells (200) doped with the opposite type are implanted in order to form multiple p-n junctions between which conductive gates (204) are placed for switching the active zone between an "on" state and an "off' state, and
- each channel (216; 232) traverses or occupies a place of one elementary cell located between two gates.

9. The chip according to any one of the previous claims, in which the chip is a controllable switch that is able to switch, in response to a control signal, the active zone between an "on" state where it exercises a low resistance to the passage of the current and an "off" state where it exercises resistance that is at least ten times greater to the passage of the current.

10. The chip according to any one of the previous claims, in which the smallest hydraulic diameter of the channel(s) is or are between 1 and 500 µm.

11. An electronic component, **characterized in that** the component comprises:
- a chip (4; 252, 254; 302, 304) in conformance with any one of the previous claims, in which the chip comprises at least one metallization layer (20, 22; 210, 212) that extends uniformly directly over one face of the active zone, this metallization layer being permeable to the heat-transfer fluid that flows through the channel (s) that open(s) into the active zone, and
- at least one conductive track (24, 26; 220) distributed only on a periphery of the active zone and making direct mechanical and electrical contact with the metallization layer to supply or collect current that traverses this active zone when the electronic chip is in an "on" state, the electrical contact between the conductive track (24, 26; 220) and the metallization layer (20, 22; 210, 212) being ensured only by a solderless and adhesive-free pressure-bonded contact that enables the electrical track to slide on the metallization layer in response to each temperature variation.

12. The component according to claim 11, in which at least one conductive track is a pin (316, 318) in the form of a hollow tube in an electrically conductive material, a periphery of which is electrically connected to the periphery of the active zone of the electronic chip, and in which the hollow (322, 324) of the pin is in fluid communication with said at least one channel (306) that traverses the active zone.

13. An electronic component with a 3D structure comprising:
- at least one first and one second electronic chips (252, 254) each presenting an upper face and a lower face, these electronic chips being stacked one on top of the other such that the upper face of the first electronic chip faces the lower face of the second electronic chip,
**characterized in that**:
- the first and second electronic chips (252, 254) are in conformance with any one of the previous claims 1 to 10 and the upper ends of the channel(s) (216) that open into the upper face of the first electronic chip are in fluid communication with the lower ends of the channel(s) that open into the lower face of the second electronic chip, and
- the upper and lower faces of the first and second chips (252, 254) define the upper and lower walls of an intermediate heat-transfer fluid manifold (278) housed between the first and second electronic chips into which the upper ends of the channels (216) of the first electronic chip and the lower ends of the channels of the second electronic chip open.

14. The component according to claim 13, in which:
- the first and second electronic chips (252, 254) each comprise at least one metallization layer (210, 212) that extends uniformly directly on one face, respectively lower and upper, of the active zone, this metallization layer being permeable to the heat-transfer fluid that flows in the channel(s) that open into the active zone, and
- at least one common conductive track (272) distributed only on the periphery of the active zone of each chip and making direct mechanical and electrical contact with the metallization layers that extend over the lower face of the active zone of the first chip and over the upper face of the active zone of the second chip to supply or collect current that traverses these active zones.

15. A switching arm comprising:
- voltage input and output terminals (331A, 331B),
- at least two controllable switches (252, 254) connected in series between these input and output terminals, and
- at least one decoupling capacitor (334) equipped with at least two electrodes electrically connected, respectively, to the input and output terminals, and with a dielectric material that electrically insulates these two electrodes from each other,
**characterized in that** each controllable switch (252, 254) comprises an electronic chip in conformance with any one of claims 1 to 10, and the decoupling capacitor (334) comprises at least one of a channel (338) that traverses the dielectric material between the electrodes or extends directly along at least one of the electrodes, this channel or these channels being in fluid communication with the channels (216) traversing the active zones of the electronic chips forming the controllable switches.
